(19) Europäisches Patentamt / European Patent Office / Office européen des brevets

(11) **EP 2 211 470 B1**

(12) **EUROPEAN PATENT SPECIFICATION**

(45) Date of publication and mention of the grant of the patent:
**07.09.2011 Bulletin 2011/36**

(51) Int Cl.:
*H03M 13/11* *(2006.01)*

(21) Application number: **09100070.3**

(22) Date of filing: **26.01.2009**

(54) **Generating an exponent table for coding and decoding LDPC codewords of different lengths**

Erzeugung einer Exponententabelle für die Codierung und Decodierung von LDPC-Codes unterschiedlicher Länge

Génération d'une table exponentielle pour le codage et le décodage des codes LDPC de longueur différente

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**28.07.2010 Bulletin 2010/30**

(73) Proprietor: **Nokia Siemens Networks Oy 02610 Espoo (FI)**

(72) Inventor: **Cannalire, Giacomo Francesco 20062 Cassano d'Adda (IT)**

(74) Representative: **Fischer, Michael
Nokia Siemens Networks GmbH & Co. KG
COO RTP IPR, Patent Administration
80240 München (DE)**

(56) References cited:
**US-A1- 2006 123 277     US-A1- 2007 094 580**

- IEEE: "IEEEStd 802.16e-2005, Air Interface For Fixed and Mobile Broadband Wireless Access Systems" IEEE 802.16E, 28 February 2006 (2006-02-28), pages 626-630, XP002515198
- ECHARD R ET AL.: "The extended irregular "pi" - rotation LDPC codes" IEEE COMMUNICATIONS LETTERS, IEEE SERVICE CENTER, PISCATAWAY, NJ, US, vol. 7, no. 5, 1 May 2003 (2003-05-01), pages 230-232, XP011096589 ISSN: 1089-7798

**Description**

**FIELD OF THE INVENTION**

The present invention relates to fixed and mobile Broadband Wireless Access Networks implementing LDPC (Low Density Parity Check) block coding both at the channel encoder and decoder, in special way those networks compliant with the current IEEE 802.16e standardization [Ref.1], as recited in the preamble of claim 1. The invention is directed to generating a multi-length exponent table for coding and decoding LDPC codewords of different lengths. The method is devoted to LDPC block codes built up by keeping both spreading factor $Z_f$ and code rate $R$ constant.

According to [Ref.2], a linear block code consists of a set of fixed-length vectors called "codewords". The length of a codeword is the number of elements in the vector and is denoted by $n$. The elements of a codeword are selected from an alphabet of $q$ elements. When the alphabet consists of two symbols , 0 and 1, the code is a binary code and the elements of any codeword are called bits. There are $2^n$ possible codewords in a binary block code of length $n$. From these $2^n$ codewords, we may select $M = 2^k$ codewords ($k < n$) to form a code. Thus a block of $k$ information bits is mapped into a codeword of length $n$ selected from the set of $M = 2^k$ codewords. As known in the art, a LDPC code is simply a block code defined by a parity-check matrix that has a low density of ones (i.e. mostly zeros). Decoding is done iteratively using Belief Propagation (BP), to say, passing of extrinsic information between codeword elements and parity check equations. LDPC codes have the following advantages: **1)** designs have approached channel capacity within 0.0045 dB; **2)** structured designs offer the great performance with faster convergence and attractive silicon solutions; **3)** structured LDPC is a viable and attractive solution with significant gains over the legacy FEC system.

It is noted that the term "exponent matrix" is an expression widely used in the LDPC block coding/decoding art to conventionally denote a matrix whose elements, also called "exponents", represent permutation matrix of the $Z_f \times Z_f$ identity matrix; the null matrix, which is conventionally expressed by the element (-1), has also $Z_f \times Z_f$ dimensions. A permutation matrix is obtained by operating a right circular shift of the identity matrix of as many positions as its exponent. Consequently, sometimes in the art the term "exponent" used for the elements of the exponent matrix may be replaced with the equivalent term "shift-size".

**BACKGROUND ART**

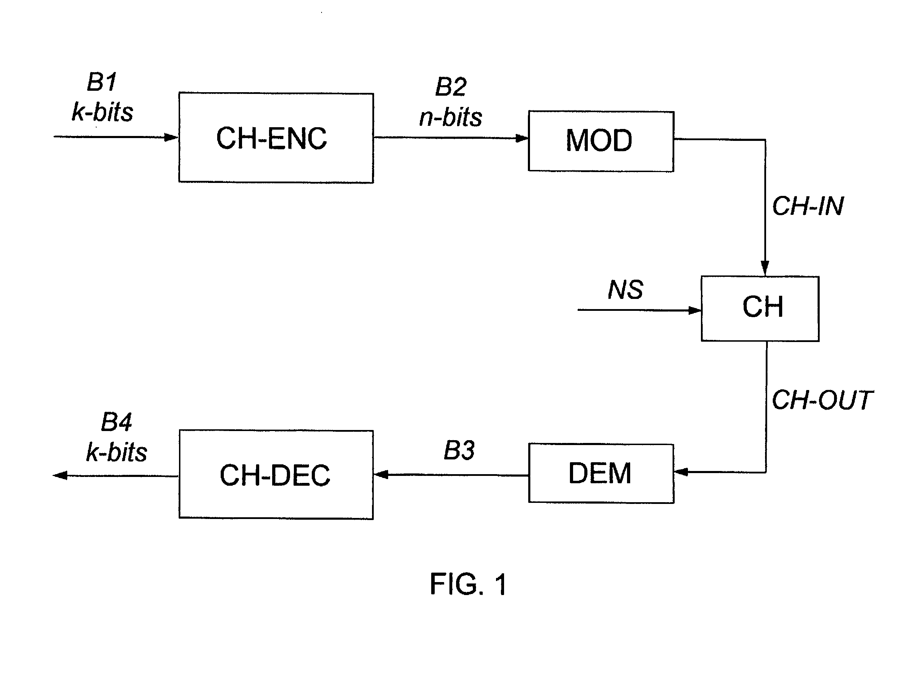

Let us consider a schematic example of a digital communication system model as the one shown in the block diagram of **Figure 1.**

The input of channel encoder CH_ENC is an information sequence *B1* of $k$ bits to which a redundancy sequence of $r$ bits is added thereby producing an encoded sequence *B2* of $n$ bits.

The channel code rate $R$ is defined as the ratio between the information bits number $k$ and the encoded bits number $n$, thus $R = k/n$.

Modulator MOD transforms the encoded vector *B2* into a modulated signal vector *CH_IN* which is in turn transmitted through a channel CH. Since the channel CH is usually subject to noisy disturbance *NS*, the channel output signal *CH_OUT* may differ from the channel input signal *CH_IN.*

At the receiving end, the channel output signal *CH_OUT* is processed by the demodulator DEM which performs the inverse operation of the modulator MOD and produces some likelihood ratio.

The channel decoder CH_DEC uses the redundancy in the received sequence *B3* to correct the error in the information sequence of the received sequence *B3* and produces a decoded signal *B4* which is an information signal estimate.

State of the art encoder/decoder structures CH_ENC, CH_DEC use LDPC codes as proposed by the IEEE 802.16e Standard for Air Interface For Fixed and Mobile Broadband Wireless Access Systems [Ref.1].

LDPC codes are linear block codes. Linear block codes use a generator matrix G for the encoding operation and a parity-check matrix **H** for the decoding operation; nevertheless in its turn matrix **G** is most suitably obtained starting from designing the parity-check matrix $\mathbf{H}_{r \times n}$; obviously also the vice versa is possible. In conclusion, the parity-check matrix **H** can be used both for LDPC encoding and decoding.

For a block code with information sequence of $k$ bits, a codeword of $n$ bits and redundancy (parity) sequence of $r = n - k$ bits, the generator matrix **G** has $k \times n$ dimensions, and the parity-check matrix **H** has $r \times n = (n-k) \times n$ dimensions.

These two matrixes enjoy the orthogonal property, which states that for any ($k \times n$) matrix with $k$ linearly independent rows, there exists a matrix $\mathbf{H}_{r \times n}$ with $r = n - k$ linearly independent rows such that any row of $\mathbf{G}_{k \times n}$ is orthogonal to the rows of $\mathbf{H}_{r \times n}$ such that the following equation is satisfied:

$$\mathbf{G}_{k\times n} \cdot \mathbf{H}^{T}_{r\times n} = 0$$

$$(1)$$

The encoding operation is performed by means of the multiplication between the information sequence $\mathbf{U}_{1\times k}$ and the code generator matrix $\mathbf{G}_{k\times n}$. The result, of such multiplication, is the encoded output sequence $\mathbf{V}_{1\times n}$ as follows:

$$\mathbf{V}_{1\times n} = \mathbf{U}_{1\times k} \cdot \mathbf{G}_{k\times n}$$

$$(2)$$

At the receiving side, due to the orthogonal property between matrixes $\mathbf{G}_{k\times n}$ and $\mathbf{H}_{r\times n}$, the following equation should be satisfied:

$$\mathbf{H}_{r\times n} \cdot \mathbf{B}^{T}_{n\times 1} = 0$$

$$(3)$$

where $\mathbf{B}^{T}_{n\times 1}$ is the decoded received sequence which comprises the information signal estimate B4. If equation (3) is verified the information signal estimate B4 is correct otherwise the errors in the received sequence B3 exceed the correction capacity of the carried-out code.

The parity-check binary matrix $\mathbf{H}_{r\times n}$ is built combining in a certain manner three matrixes: the parity-check exponent matrix $\mathbf{H}_{exp}$ for a specific rate $R$; the "seed matrix" for that rate $R$, and the "spreading matrix" for a given spreading factor $Z_f$.

The exponent matrix is a non-binary matrix representing a block structured matrix.

The seed matrix is a binary matrix dedicated to each code rate for masking the exponent matrix according to a compromise between performances and hardware complexity.

The spreading matrix is a square binary matrix of weight one and dimension $Z_f \times Z_f$, being $Z_f$ the desired spreading factor which in the known art is tied to the codeword length of the LDPC code.

In operation, the non-binary parity-check exponent matrix $\mathbf{H}_{exp}$ is element-by-element multiplied by the seed matrix; the result is a an opportunely masked $\mathbf{H}_{exp}$ matrix, which in turn is expanded to the parity-check binary matrix $\mathbf{H}_{r\times n}$ (hereby also called expanded matrix $\mathbf{H}_{r\times n}$).

There are several design techniques for generating the parity-check matrix $\mathbf{H}_{r\times n}$ of a LDPC code. The most used generating technique in LDPC code design is the semi-random technique.

When realized with semi-random technique, the expanded matrix $\mathbf{H}_{r\times n}$ is constituted of two sub-matrixes: the first sub-matrix is a random matrix having $(n - k) \times k = r \times k$ size and the second one is a sub-matrix of $(n - k) \times (n - k) = r \times r$ size, conventionally called semi-deterministic sub-matrix.

It is noted that the exponent matrix is typically built with the maximum spreading factor $Z_0$ which corresponds to the maximum codeword size. However, it is possible to implement codewords of variable sizes.

When a different codeword size is desired, whose size is smaller than the maximum size, a spreading factor $Z_f$ smaller than $Z_0$ is required. In such cases, it is possible to convert the exponent matrix built with maximum spreading factor $Z_0$ into an exponent matrix having spreading factor $Z_f < Z_0$ by using some translation formulas as, for example, relation (129a) reported in IEEE 802.16e Standard [Ref.1] at page 627.

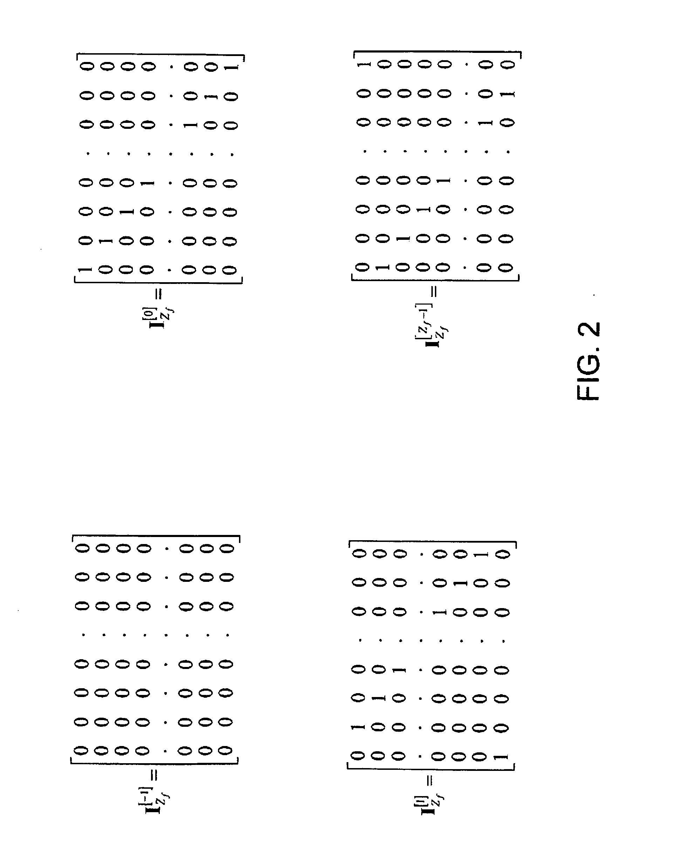

The elements of the parity-check exponent matrix $\mathbf{H}_{exp}$ comprised between 0 and $Z_f - 1$ represent permutation matrixes of the identity matrix (the one with weight equal to "1" for each row and for each column) with dimensions $Z_f \times Z_f$. The exponent indicates the size of circular shift to the right of the row elements of the identity matrix, as shown in the matrixes $\mathbf{I}^{[0]}_{Z_f}, \mathbf{I}^{[1]}_{Z_f}, \ldots, \mathbf{I}^{[Z_f-1]}_{Z_f}$ reported in **figure 2.** The exponent matrix element "**-1**" conventionally represents a null square matrix of size $Z_f \times Z_f$, as shown in the matrix $\mathbf{I}^{[-1]}_{Z_f}$ further reported in **figure 2.** All non-negative exponents have meaning, for example the "0" exponent corresponds to the identity matrix element. The skilled in the art easily understands that same benefits may be obtained if the cyclic shift is a cyclic shift to the left instead than a one to the right.

The parity-check exponent matrix $\mathbf{H}_{exp}$ is used in the implementation of both LDPC encoder and LDPC decoder. The IEEE 802.16e [Ref.1] shows a method for LDPC encoding (Method 2) which allows to reduce the LDPC encoder hardware complexity, on condition that the parity-check exponent matrix $\mathbf{H}_{exp}$ is opportunely built with semi-random techniques. Accordingly, matrix $\mathbf{H}_{exp}$ is split into a random sub-matrix ($r_b \times k_b$), and the semi-deterministic sub-matrix ($r_b \times r_b$). In its turn the semi-deterministic sub-matrix is split into a conventionally called semi-deterministic column vector $\mathbf{C}v$ ($r_b \times 1$), constructed in an opportune way, and a deterministic part which includes a bi-diagonal matrix as known from the art. The cited Method 2 imposes that the column vector $\mathbf{C}v$ has only three elements different from "-1", representing the null matrix, that the first and the last element are equal, and that only one randomly chosen element is equal to "0", representing the identity matrix.

## HIGHLIGHTED THECHNICAL PROBLEM

According to [Ref.1], a base model parity-check exponent matrix $\mathbf{H}_{exp}$ is defined for the largest code length. The set of exponents in the base model are used to determine the shift sizes for all other code lengths of the same channel code rate $R$. Let us consider an LDPC code with $R = 13/16$ exemplary rate; the largest information sequence $k_0 = 8424$ and the highest spreading factor $Z_0 = 108$.

The largest LDPC codeword length $n_0$ is computed from the largest information sequence and from the channel code rate $R$ as follows:

$$n_0 = k_0 / R = 10368$$

The column *number* $n_b$ of the block structured base model $\mathbf{H}_{exp}$ is computed from the largest codeword length $n_0$ and the highest spreading factor $Z_0$ as follows:

$$n_b = n_0 / Z_0 = 96$$

the block structured information sequence $k_b$ is computed from the largest information sequence $k_0$ and the highest spreading factor $Z_0$ as follows:

$$k_b = k_0 / Z_0 = 78$$

and the row number $r_b$ is computed from the column *number* $n_b$ and block info sequence $k_b$ as follows:

$$r_b = n_b - k_b = 18 .$$

According to [Ref.1], the passage from the base model $\mathbf{H}_{exp}$ (maximum spreading factor $Z_0$) to the wished exponent matrix for a shorter codeword of the same code rate, is carried-out using some relations as, for example, that shown in [Ref.1] - page 627 - equation (129a). In such a way it is possible to carry-out shorter LDPC codewords ($n < n_0$) than base model's codeword ($n_0$) using a spreading factor $Z_f < Z_0$, as shown in **Table 1** below.

| $Z_f$_spread | n_codeword | k_info | r_parity |
|---|---|---|---|
| 108 | 10368 | 8424 | 1944 |
| 90 | 8640 | 7020 | 1620 |
| 72 | 6912 | 5616 | 1296 |
| 54 | 5184 | 4212 | 972 |
| 36 | 3456 | 2808 | 648 |

For every spreading factor $Z_f$ selected from Table 1, a corresponding model $\mathbf{H}_{exp}$ shall be computed using a conversion relation as reported in [Ref.1].

As known in the art, the length of the codeword depends on various factors, for example: to the needed robustness of the code for counteracting possible transmission errors due to unforeseeable impairments on the radio channel; or to the degree of importance of some sub-sequences of the information sequence (e.g. the message header), etc. In any case, according to [Ref.1], page 630, the encoding block size $k$ shall depend on the number of subchannels allocated and the modulation specified for the current transmission.

A remarkable characteristic of a modern wireless communication system is that to comply with adaptive Modulation and Coding Scheme (MCS) changing dynamically the length of the codeword (and, if requested, the type of modulation). It can be argued that the actual WiMAX-compliant systems have some difficulties to operate accordingly. In fact, for a selected code rate $R$, an exponent matrix dedicated to a specific spreading factor $Z_f$ has to be stored in correspondence of every length $n_j$ of the codeword. Table 333a at pages 629 and 630 of [Ref.1] reports well nineteen spreading factors $Z_f$ for every channel code rate $R$ to comply with different lengths of the codeword. This means, in the worst case, providing room up to nineteen different exponent matrixes for each channel code rate $R$: a very demanding task indeed. Alternatively to the wide storage requirements, the actual parity-check exponent matrix $\mathbf{H}_{exp}$ shall be calculated according to said relation 129a at [Ref.1], but a great deal of processing resources must be devoted to this task.

It is therefore an object of the present invention to overcome the above mentioned drawbacks and minimizing both the storage and processing requirements for achieving exponent matrixes built by the same channel code rate $R$ and the same spreading factor $Z_f$ but different lengths of codewords.

## SUMMARY OF THE INVENTION

The invention achieves said object by providing a method of encoding information sequences of $k$ bits using low-density parity check code exponent matrixes, each element of which, namely the exponent, being expanded into a permutation matrix by a cyclic shift of the identity matrix with a shift-size corresponding to the value of said exponent, and every parity-check exponent matrix being composed of two contiguous sub-matrixes with the same number $r_b$ of rows, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$ - 1 columns and a first column vector whose elements have a value which represents the null matrix with the only exception of the first and the last element that include a same randomly selected exponent, and of a third element in a random position between the twos having a value which represents the identity matrix, the method including the following steps:

a) providing a main table of $r_b$ rows and $k_b$ + 1 columns and filling it with random values included in a range of allowed exponents, starting from: the longest codeword length $n_0$, the longest information sequence $k_0$, a fixed code-

rate $R = \dfrac{k_0}{n_0}$ , a fixed spreading factor $Z_0$, being $n_b = \dfrac{n_0}{Z_0}$ , $k_b = \dfrac{k_0}{Z_0}$ , and $r_b = n_b$ - $k_b$;

b) calculating for any allowed integer $x$ inclusive of zero: a first corresponding integer $k_{b\_x} = (k_b - c_1 x)$, a second corresponding integer $n_{b-x} = (n_b - c_2 x)$, and a third corresponding integer $r_{b\_x} = n_{b\_x} - k_{b\_x}$, being $c_1$ and $c_2$ integers

such that $\dfrac{c_1}{c_2} = R$ without any common divisor, and $\cdot_{b-x}$ a subscript associated to integer $x$ ;

c) for any allowed integer $x$, delimiting in the main table, starting from its initial element, a corresponding sub-table of $r_{b\_x}$ consecutive rows and $k_{b\_x}$ + 1 consecutive columns, and for every sub-table processing modulo $Z_0$ two unprocessed rows of the main table to fulfil on the last column of the sub-table the conditions posed on the first column vector of said composite sub-matrix;

d) for any allowed integer $x$ and a corresponding codeword of length $n_{b\_x}$, providing an exponent matrix including the sub-table for that $x$ plus a deterministic sub-matrix for that $x$ of $r_{b\_x}$ rows and of $r_{b\_x}$ - 1 columns, and replacing the unprocessed elements of the last column of said sub-table with a conventional value which corresponds to the null matrix, as disclosed in claim 1.

Other object of the invention is a method of decoding LDPC codewords in which the exponent matrixes associated to codewords of different lengths are built with the same steps of encoding.

Other object of the invention is a system having means operating according to the steps of the method disclosed in the appended claims.

Additional features of the present invention which are believed to be novel are set forth with particularity in the appended claims.

According to the invention, the processing at step c) includes:

c1) choosing a first unprocessed row having index $r_{b\_x}$;
c2) choosing a second unprocessed row randomly among those having index $r_{b\_x}$ and 1, both excluded, and the remaining unprocessed rows;
c3) obtaining a first exponent by subtracting modulus $Z_0$, the element of said first unprocessed row positioned in column $k_{b\_x} + 1$ from the element positioned in the first row and in column $k_{b\_x} + 1$;
c4) adding modulus $Z_0$ said first exponent to every elements of said first unprocessed row;
c5) obtaining a second exponent by subtracting modulus $Z_0$ the element of said second unprocessed row positioned in column $k_{b\_x} + 1$ from the integer zero;
c6) adding modulus $Z_0$ said second exponent to every elements of said second unprocessed row.

The main table processed as above includes the random part of LDPC codes of the same rate but different lengths, for this reason it is called "multi-length" hereafter.

According to the invention, for $x = 0$ the corresponding sub-table is sized as the main table to comply with full-length codewords.

According to the invention, step d) leaves the multi-length table unchanged.

## ADVANTAGES OF THE INVENTION

The proposed invention allows less expensive channel encoder/decoder equipments, since an unique model table shall be stored for deriving several exponent matrixes $\mathbf{H}_{exp}$ for variable length codewords.

The proposed invention allows dynamic changes of the coding scheme, since the required processing is lapsed in a short time.

All processing steps of the proposed method do not change the block structured exponent matrix characteristics.

Moreover, said processing steps do not change the characteristics of the expanded parity-check matrix of being a binary matrix with a low density of "1".

The above characteristics keep low the storage requirements and the hardware complexity of the LDPC code implementation.

## BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **figure 1** shows a block diagram schematically illustrating a suitable digital communication system for implementing the present invention;

- **figure 2** shows different permutation matrixes, wherein, $\mathbf{I}_{z_f}^{[-1]}$ corresponds to the null matrix and $\mathbf{I}_{z_f}^{[0]}, \mathbf{I}_{z_f}^{[1]}, \mathbf{I}_{z_f}^{[z_f-1]}$ correspond to a cyclic shift to the right of the identity matrix for a shift-size indicated by the exponent;

- **figure 3** shows a random **Table 2** of known art used as a starting point to implement the method of the present invention;

- **figure 4** shows the random table of figure 3 after being processed to delimit a first sub-table usable for obtaining an exponent matrix for codewords of length L1 for a fixed code rate and fixed spreading factor;

- **figure 5** shows the processed table of figure 4 after being further processed to delimit a second sub-table usable for obtaining an exponent matrix for codewords of length L2 > L1 for the same code rate and spreading factor;

- **figure 6** shows the processed table of figure 5 after being further processed to delimit a third sub-table usable for obtaining an exponent matrix for codewords of length L3 > L2 for the same code rate and spreading factor;

- **figure 7** shows an exponent matrix obtained by isolating the innermost sub-table from the nested sub-tables of figure 6 and completing it with a deterministic contiguous matrix.

## DETAILED DESCRIPTION OF SOME EMBODIMENTS OF THE INVENTION

Let us consider a base model parity-check exponent matrix $\mathbf{H}_{exp}$ with the following characteristics of the LDPC code:

$$R = 13/16, \quad Z_0 = 108 \text{ a fixed spreading factor,}$$
$$n_0 = 10368, \quad k_0 = 8424, \quad r_0 = 1944,$$
$$n_b = 96, \quad k_b = 78, \quad r_b = 18,$$

wherein $R = \dfrac{k_b}{n_b} = \dfrac{c_1}{c_2} = \dfrac{13}{16}$, $c_1 = 13$ and $c_2 = 16$ are minimal term reduced values, that is $c_1$ and $c_2$ have not more common division values.

To obtain shorter LDPC codewords than base model codeword, under the constraints of having fixed both the code rate, e.g. $R = 13/16$ and the spreading factor $Z_f$, corresponding to the spreading factor $Z_0 = 108$, the following relation has to be applied:

$$R = \frac{k_b - c_1 \cdot x}{n_b - c_2 \cdot x} , \tag{4}$$

with $x = 0, 1, 2, 3, \dots\dots$ , integer values limited by the mean column weight ($w_c$) of the exponent matrix, which is tied to the LDPC code performances.

Using relation (4) and assigning to the parameter $x$, in turn, the values 0, 1, 2, 3, and 4, it is possible obtaining sub-tables for LDPC codewords of different length $n_j$, as will be described below. This involves repeated processing of the base model exponent table to obtain nested sub-tables in a multi-length table.

$$\textbf{Case} \quad x = 0 \quad \Rightarrow \quad R = \frac{k_b}{n_b} = \frac{78}{96} = \frac{13}{16},$$

with x = 0 we have the base model LDPC code with the largest codeword length ($n_0 = n_b \cdot Z_0 = 10368$): the block structured exponent matrix $\mathbf{H}_{exp\_0}$ is composed of $n_b = 96$ columns and $r_b = n_b - k_b = 18$ rows.

$$\textbf{Case} \quad x = 1 \quad \Rightarrow \quad R = \frac{k_b - c_1}{n_b - c_2} = \frac{78 - 13}{96 - 16} = \frac{k_b\_1}{n_b\_1} = \frac{65}{80} = \frac{13}{16},$$

with x = 1 we have $k_{b\_}1 = 65$, $n_{b\_}1 = 80$ and LDPC codeword length ($n = n_{b\_}1 \cdot Z_0 = 8640$); the block structured exponent matrix $\mathbf{H}_{exp\_1}$ is composed of $n_{b\_}1 = 80$ columns and $r_{b\_}1 = n_{b\_}1 - k_{b\_}1 = 15$ rows.

Then to obtain the latter LDPC code ($n = 8640$) it is necessary to eliminate ($c_1 \cdot x$-1) = 12 columns with highest indexes (67 to 78) from the base model exponent matrix $\mathbf{H}_{exp}$, and further eliminating the semi-deterministic column vector $\mathbf{C}v$ (column index = 79). Moreover because the code rate R remains unchanged, it is necessary to eliminate also ($c_2 - c_1$) $\cdot x$ = 3 rows, with highest indexes (16 to 18) from the base model exponent matrix $\mathbf{H}_{exp}$.

$$\text{\textbf{Case}}\quad x = 2 \quad \Rightarrow \quad R = \frac{k_b - c_1 \cdot 2}{n_b - c_2 \cdot 2} = \frac{78 - 26}{96 - 32} = \frac{k_b\_2}{n_b\_2} = \frac{52}{64} = \frac{13}{16},$$

with x = 2 we have $k_{b}\_2 = 52$, $n_{b}\_2 = 64$ and LDPC codeword length ($n = n_{b}\_2 \cdot Z_0 = 6912$); the block structured exponent matrix $\mathbf{H}_{exp\_2}$ is composed of $n_{b}\_2 = 64$ columns and $r_{b}\_2 = n_{b}\_2\text{-}k_{b}\_2 = 12$ rows.

The LDPC code ($n = 6912$) is obtained eliminating, from the base model exponent matrix $\mathbf{H}_{exp}$, ($c_1 \cdot x$ - 1) = 25 columns of the random sub-matrix, with highest indexes (54 to 78), the semi-deterministic column vector $\mathbf{C}v$ (column index = 79), and ($c_2$ - $c_1$) $\cdot$ $x$ = 6 rows with highest indexes (13 to 18).

$$\text{\textbf{Case}}\quad x = 3 \quad \Rightarrow \quad R = \frac{k_b - c_1 \cdot 3}{n_b - c_2 \cdot 3} = \frac{78 - 39}{96 - 48} = \frac{k_b\_3}{n_b\_3} = \frac{39}{48} = \frac{13}{16}$$

with x = 3 we have $k_{b}\_3 = 39$, $n_{b}\_3 = 48$ and LDPC codeword length ($n = n_{b}\_3 \cdot Z_0 = 5184$); the block structured exponent matrix $\mathbf{H}_{exp\_3}$ is composed of $n_{b}\_3 = 48$ columns and $r_{b}\_3 = n_{b}\_3\text{-}k_{b}\_3 = 9$ rows.

The LDPC code ($n = 5184$) is obtained eliminating, from the base model exponent matrix $\mathbf{H}_{exp}$, ($c_1 \cdot x$ - 1) = 38 columns of the random sub-matrix, with highest indexes (41 to 78), the semi-deterministic column vector $\mathbf{C}v$ (column index = 79), and ($c_2$ - $c_1$) $\cdot$ $x$ = 9 rows with highest indexes (10 to 18).

$$\text{\textbf{Case}}\quad x = 4 \quad \Rightarrow \quad R = \frac{k_b - c_1 \cdot 4}{n_b - c_2 \cdot 4} = \frac{78 - 52}{96 - 64} = \frac{k_b\_4}{n_b\_4} = \frac{26}{32} = \frac{13}{16},$$

with x = 4 we have $k_{b}\_4 = 26$, $n_{b}\_4 = 32$ and LDPC codeword length ($n = n_{b}\_4 \cdot Z_0 = 3456$); the block structured exponent matrix $\mathbf{H}_{exp\_4}$ is composed of $n_{b}\_4 = 32$ columns and $r_{b}\_4 = n_{b}\_4\text{-}k_{b}\_4 = 6$ rows.

The LDPC code ($n = 3456$) is obtained eliminating, from the base model exponent matrix, ($c_1 \cdot x$-1) = 51 columns of the random sub-matrix, with highest indexes (28 to 78), the semi-deterministic column vector $\mathbf{C}v$ (column index = 79), and ($c_2$ - $c_1$) $\cdot$ $x$ = 12 rows with highest indexes (7 to 18).

### *Preliminary considerations to numerical examples*

The exponent matrix $\mathbf{H}_{exp}$ is built with semi-random technique; the random sub-matrix has size $r_b \times k_b$, the semi-deterministic column vector $\mathbf{C}v$ has size $r_b \times 1$ and the deterministic sub-matrix has size $r_b \times (r_b$ - 1). We want to build an LDPC code, for example, for implementing three codeword lengths, and exactly:

$$n_0 = 10368 \quad \Rightarrow \quad x = 0$$

$$n_1 = 8640 \quad \Rightarrow \quad x = 1$$

$$n_3 = 5184 \quad \Rightarrow \quad x = 3$$

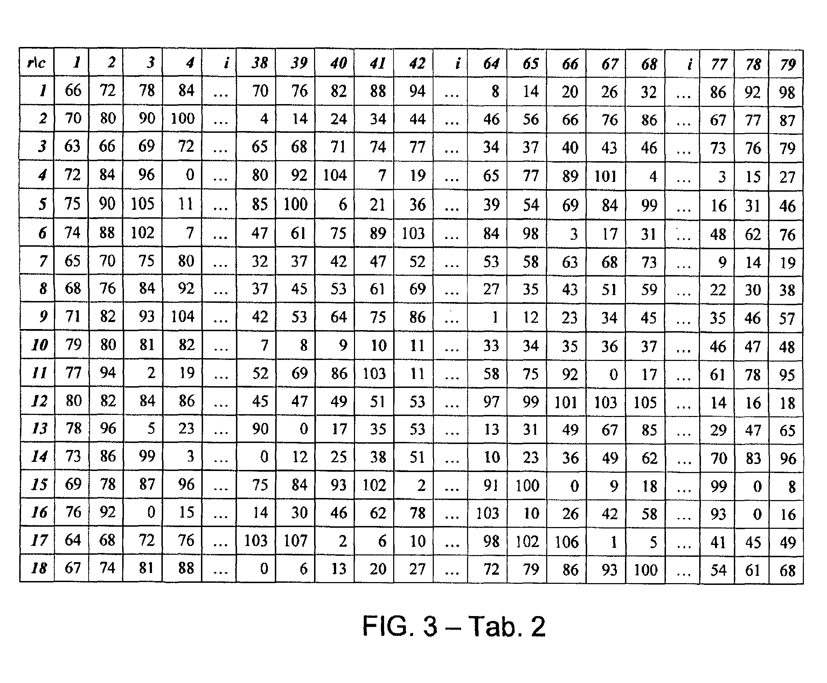

Let us assume having built the random **Table 2** shown in **figure 3** with spreading factor $Z_0 = 108$ for a fixed code rate $R = \dfrac{13}{16}$. **Table 2** includes a random sub-table of $r_b \times k_b = 16 \times 78$ elements disposed in $r_b$ rows and $k_b$ columns, and a semi-deterministic column of $r_b \times 1 = 16 \times 1$ elements, corresponding to the column 79. Alternative embodiments of **Table 2** including elements of different values are known in the art. In order to generate a multi-length table, as said above, two rows of **Table 2** are dedicated for each codeword length and an opportune processing is performed in order to satisfy the conditions on the semi-deterministic column, as exemplified below.

**Required processing for codeword length $n_3$**

For codeword length $n_3$ = 5184 ($x$ = 3) and code rate $R$ = 13/16, the dedicated exponent matrix $\mathbf{H}_{exp-3}$ has dimensions $r_{b\_3} \cdot n_{b\_3}$, where:

$$k_{b\_3} = k_b - c_1 \cdot x = 39$$

$$n_{b\_3} = n_b - c_2 \cdot x = 48$$

$$r_{b\_3} = n_{b\_3} - k_{b\_3} = (n_b - k_b) - (c_2 - c_1) \cdot x = 9$$

The semi-deterministic column vector $\mathbf{C}v_{-3}$ is located at position $cl_3$, where $cl_3 = k_{b\_3} + 1 = n_{b\_3}-(r_{b\_3}-1) = 40$, and includes $r_{b\_3}$ elements. The conditions on the semi-deterministic column vector $\mathbf{C}v_{\_3}$ impose that the column vector $\mathbf{C}v_{\_3}$ has only three elements having value different from "-1" (the conventional exponent of the null matrix); the first element of the column vector $\mathbf{C}v_{\_3}$, with coordinates $(1, cl_3) = (1,40)$, and the last column element, with coordinates $(r_{b\_3}, cl_3) = (9,40)$, must be equal, and only one of all the remaining elements, with coordinates $(2, cl_3)$, $(3, cl_3)$,......,$(8, cl_3)$, must be equal to the exponent "0" which corresponds to the identity matrix.

Then, for LDPC codeword length $n_3$ = 5184 ($x$ = 3), the following two rows are dedicated:

- the ninth row, in mandatory way; the coordinates of the column element in the ninth row being $(r_{b\_3}, cl_3) = (9,40)$
- the fourth row chosen, in random way, between second and eighth row, the coordinates of the column element in the fourth row being $(4, cl_3) = (4,40)$

The above-mentioned two rows, after being modified by the processing described below, belong to the multi-length exponent table and they cannot be dedicated to any remaining codeword lengths , e.g. $n_0$ = 10368 ($x$ = 0) and $n_1$ = 8640 ($x$ = 1).

In order to satisfy the conditions on the column vector $\mathbf{C}v_{\_3}$ for which element $(r_{b-3}, cl_3) = (9,40)$ must be equal to element $(1, cl_3) = (1,40)$, the matrixes represented by the elements in row $r_{b\_3}$ are multiplied by the permutation matrix of the identity matrix of exponent $e_{b\_3}$ calculated by means of expression (5) below.

$$e_{b\_3} = \mathrm{mod}\left\{\left[(1,cl_3) - (r_{b\_3},cl_3)\right], Z_0\right\} = 18 \,. \tag{5}$$

Expression (5) is a modulus function having the following syntax $\mathrm{mod}(x,y) = x \bmod y$, wherein $x$ is the square brackets term and $y$ is $Z_0$. The modulus function if $y \neq 0$ returns $x-n \cdot y$ where $n = floor(x/y)$. Specifically for the element (9,40) it results: $\mathrm{mod}[(82-64),108] = \mathrm{mold}(18, 108) = 18-0=18$.

Multiplication between unitary weight permutation matrixes can be implemented by calculating $(r_{b\_3}, j)$ as shown in expression (6) below which is an easy computation:

$$(r_{b\_3}, j) = \mathrm{mod}\left\{\left[e_{b\_3} + (r_{b\_3}, j)\right], Z_0\right\}, \tag{6}$$

with column number $j$ = 1,2,3,......,$k_b$ +1=79.

In order to satisfy the conditions on the column vector $\mathbf{C}_{v\_3}$ for which element $(4, cl_3) = (4,40)$ must be equal to zero, representing the identity matrix, the matrixes represented by the elements of the fourth row are multiplied by the identity permutation matrix of exponent $e_{-3}$ calculated by expression (7) below:

$$e_{\_3} = \mathrm{mod}\left\{[0-(4,cl_3)], Z_0\right\} = 4 \tag{7}$$

The multiplication between unitary weight permutation matrixes can be implemented by calculating $(4,j)$ as shown in expression (8) below which is an easy computation:

$$(4,j) = \mathrm{mod}\left\{\left[e_{\_3}+(r_4,j)\right], Z_0\right\} \tag{8}$$

with column number $j$ = 1, 2, 3,......,$k_b$ + 1 = 79.

The results of these processing steps performed on the random Table 2 of figure 3 produce a single-length **Table 3** to carry-out the LDPC codeword length $n_3$ = 5184 ($x$ = 3).

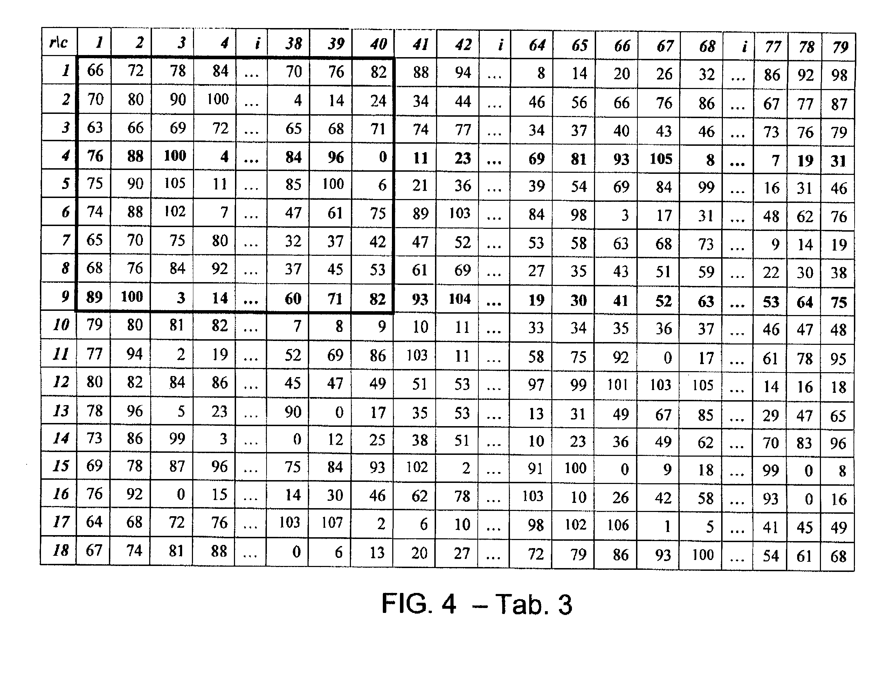

**Table 3** is shown in **Figure 4,** where the only two rows **4** and **9,** highlighted in bold, have been modified, and these rows are the twos dedicated to the LDPC codeword $n_3$ = 5184. **Table 3** includes a thick-line framed sub-table **T**$_{\mathrm{exp}\_3}$ including 360 elements delimited by the first $r_{b\_3}$ = 9 rows and the first $k_{b\_3}$ + 1 = 40 columns of **Table 3.**

The single-length **Table 3** of **figure 4** is an intermediate step for building a multi-length base model table that will be gradually upgraded in the next figures.

### *Required processing for codeword length $n_1$*

For codeword length $n_1$ = 8640 ($x$ = 1) and code rate $R$ = 13/16, the exponent matrix **H**$_{\mathrm{exp}-1}$ has size $r_{b\_1} \cdot n_{b\_1}$, where:

$$k_{b\_1} = k_b - c_1 \cdot x = 65,$$

$$n_{b\_1} = n_b - c_2 \cdot x = 80,$$

$$r_{b\_1} = n_{b\_1} - k_{b\_1} = (n_b - k_b) - (c_2 - c_1) \cdot x = 15.$$

The semi-deterministic column vector **C**$_{v\_1}$ is located at position $cl_1$, where $cl_1 = k_{b\_1} + 1 = n_{b\_1} - (r_{b\_1} - 1) = 66$, and includes $r_{b\_1}$ elements. The only elements, of the semi-deterministic column **C**$_{v\_1}$ having value different from the conventional exponent of null matrix are the following three: the first element of the column vector **C**$_{v\_1}$ with coordinates $(1, cl_1) = (1,66)$; the last column element with coordinates $(r_{b\_1}, cl_1) = (15,66)$; and only one of the remaining elements of column **C**$v_{\_1}$ except for elements indexed by $(4, cl_1) = (4,66)$ and $(r_{b\_1}, cl_1) = (9,66)$, since the fourth and ninth rows have been dedicated to LDPC codeword length $n_3$; e.g. one of the following elements with coordinates; $(2, cl_1)$, $(3, cl_1)$, $(5, cl1)$, $(6, cl_1)$, $(7, cl_1)$, $(8, cl_1)$, $(10, cl_1)$, $(11, cl_1)$, $(12, cl_1)$, $(13, cl_1)$, $(14, cl_1)$, must be equal to "$0$" (the exponent of the identity matrix).

Then, for LDPC codeword length $n_1$ = 8640 ($x$ = 1), the following two rows are dedicated:

- the fifteenth row, in mandatory way; the coordinates of the column element in the fifteenth row being $(r_{b\_1}, cl_1) = (15,66)$;
- the eleventh row chosen, in random way, among all the possible (non-dedicated) remaining rows; the coordinates of the column element in the eleventh row being $(11, cl_1) = (11,66)$.

The above-mentioned two rows, after being modified by the processing described below, belong to the multi-length exponent table and they cannot be dedicated to any of the other remaining codeword lengths , e.g. $n_0$ = 10368 ($x$ = 0).

In order to satisfy the conditions on the column vector **C**$v_{\_1}$ for which element $(r_{b\_1}, cl_1) = (15, 66)$ must be equal to element $(1, cl_1) = (1, 66)$, the matrixes represented by the elements in row $r_{b\_1}$ are multiplied with the permutation matrix of the identity matrix of exponent $e_{b\_1}$ calculated with expression (5), putting the corresponding values of the LDPC codeword $n_1$, as shown below:

$$e_{b\_1} = \mathrm{mod}\left\{\left[(1, cl_1) - (r_{b\_1}, cl_1)\right], Z_0\right\} = 20.$$

This multiplication between unitary weight permutation matrixes can be implemented by calculating $(r_{b\_1}, j)$ as below shown, using the expression (6) but with LDPC codeword $n_1$ values:

$$(r_{b\_1}, j) = \mathrm{mod}\left\{\left[e_{b\_1} + (r_{b\_1}, j)\right], Z_0\right\}, \ \text{with column number} \ j = 1, 2, 3, ......, k_b + 1 = 79.$$

The conditions on the column vector $\mathbf{C}_{v\_1}$ impose that: the element positioned at $(11, cl_1) = (11, 66)$ is equal to zero (the exponent of the identity matrix); the matrixes represented by the elements of the eleventh row are multiplied by the permutation matrix of the identity matrix of exponent $e_{\_1}$ calculated, as already done for the previous case, with expression (7):

$$e_{\_1} = \mathrm{mod}\left\{\left[0 - (11, cl_1)\right], Z_0\right\} = 16.$$

The multiplication between unitary weight permutation matrixes can be implemented by calculating $(11, j)$ as shown below, using expression (8), which is an easy computation:

$$(11, j) = \mathrm{mod}\left\{\left[e_{\_1} + (11, j)\right], Z_0\right\}, \ \text{with column number} \ j = 1, 2, 3, ......, k_b + 1 = 79.$$

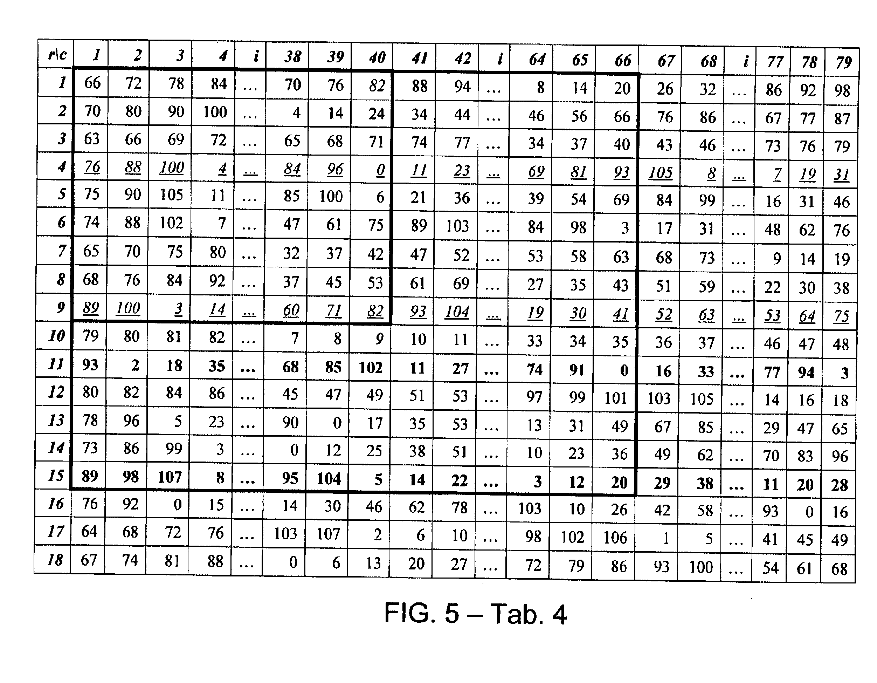

The results of these processing steps performed on the single-length exponent Table 3 of figure 4 produce a bi-length **Table 4** to carry-out the LDPC codeword lengths $n_3 = 5184$ and $n_1 = 8640$.
**Table 4** is shown in **figure 5**, where the only two rows **11** and **15,** highlighted in bold, have been modified and these rows are the twos dedicated to the LDPC codeword $n_1 = 8640$; rows *4* and *9* previously processed for codeword $n_3$ are indicated in underlined italic. **Table 4,** in addition to sub-table $\mathbf{T}_{exp-3}$, includes another thick-line framed sub-table $\mathbf{T}_{exp-1}$ overlapped to $\mathbf{T}_{exp\_3}$, and including 990 elements, delimited by the first $r_{b\_1} = 15$ rows and the first $k_{b\_1} + 1 = 66$ columns of **Table 4.**
The bi-length **Table 4** of **figure 5** is an intermediate step for building a multi-length base model table that will be further upgraded in the next figure.

### *Required processing for codeword length $n_0$*

For codeword length $n_0 = 10368$ ($x = 0$) and code rate $R = 13/16$, the exponent matrix $\mathbf{H}_{exp\_0}$ has size $r_{b\_0} \cdot n_{b-0}$, where:

$$k_{b-0} = 78, \quad n_{b-0} = 96, \quad r_{b-0} = n_{b-0} - k_{b-0} = 18.$$

The semi-deterministic column vector $\mathbf{C}v_{\_0}$ is located at position $cl_0$, where $cl_0 = k_{b\_0} + 1 = n_{b\_0} - (r_{b\_0} - 1) = 79$, and includes $r_{b-0}$ elements.
The only three elements, of column $\mathbf{C}v_{\_0}$, having value different from the element ("-1") of null matrix, are the first one positioned at $(1, cl_0) = (1, 79)$ and the last one positioned at $(r_{b-0}, cl_0) = (18, 79)$, which must be equal, and only one out of the remaining elements of column $\mathbf{C}v_{\_0}$ which must be equal to the exponent ("0") of the identity matrix. The last element of column $\mathbf{C}v_{\_0}$ must be chosen between the second and the seventeenth row with exception of the fourth, ninth, eleventh and fifteenth rows which have been dedicated to LDPC codeword lengths $n_3$ and $n_1$.

Then, for LDPC codeword length $n_0$ = 10368 ($x$ = 0), the following two rows are dedicated:

- the eighteenth row, in mandatory way; the coordinates of the column element in the eighteenth row being ($r_{b\_0}$, $cl_0$) = (18, 79);
- the sixteenth row chosen, in random way, among all the possible (not-dedicated) remaining rows; the coordinates of the column element in the sixteenth row being (16, $cl_0$) = (16, 79) :

The above-mentioned two rows, after being modified by the processing described below, belong to the multi-length base model exponent table.

The element ($r_{b\_0}$, $cl_0$) = (18, 79) must be equal to the element (1, $cl_0$) = (1,79), in order to satisfy the conditions on the column vector $\mathbf{C}v_{\_0}$; elements in row $r_{b\text{-}0}$ are multiplied by the permutation matrix of the identity matrix of exponent $e_{b\text{-}0}$ calculated with expression (5), with the corresponding values of the LDPC codeword $n_0$:

$$e_{b\_0} = \text{mod}\left\{[(1,cl_0) - (r_{b-0},cl_0)], Z_0\right\} = 30 .$$

The multiplication between unitary weight permutation matrixes can be implemented by calculating ($r_{b\_0}$, $j$), as shown below, using the expression (6), for LDPC codeword $n_0$:

$$(r_{b-0}, j) = \text{mod}\left\{\left[e_{b\_0} + (r_{b-0}, j)\right], Z_0\right\}, \quad \text{with} \quad j = 1, 2, 3, \ldots, cl_0 = k_b + 1 = 79$$

indicating the column number.

The conditions on the column vector $\mathbf{C}v_{\_0}$ impose that the element indexed (16, $cl_1$) = (16,79) is equal to zero (the exponent of the identity matrix); then the elements of the sixteenth row are multiplied by the permutation matrix of the identity matrix of exponent $e_{\_0}$ computed with expression (7):

$$e_{\_0} = \text{mod}\left\{[0 - (16, cl_0)], Z_0\right\} = 92 .$$

The multiplication between unitary weight permutation matrixes can be implemented by calculating (16, $j$) using expression (8), as shown below:

$$(16, j) = \text{mod}\left\{[e_{\_0} + (16, j)], Z_0\right\}, \text{with} \quad \text{column number} \quad j = 1, 2, 3, \ldots, cl_0 = k_b + 1 = 79 .$$

The results of these processing steps, performed on the bi-length exponent Table 4 of figure 5, produce a multilength base model exponent **Table 5** to carry-out all LDPC codeword lengths n_3 = 5184, n_1 8640 and n_0 10368.

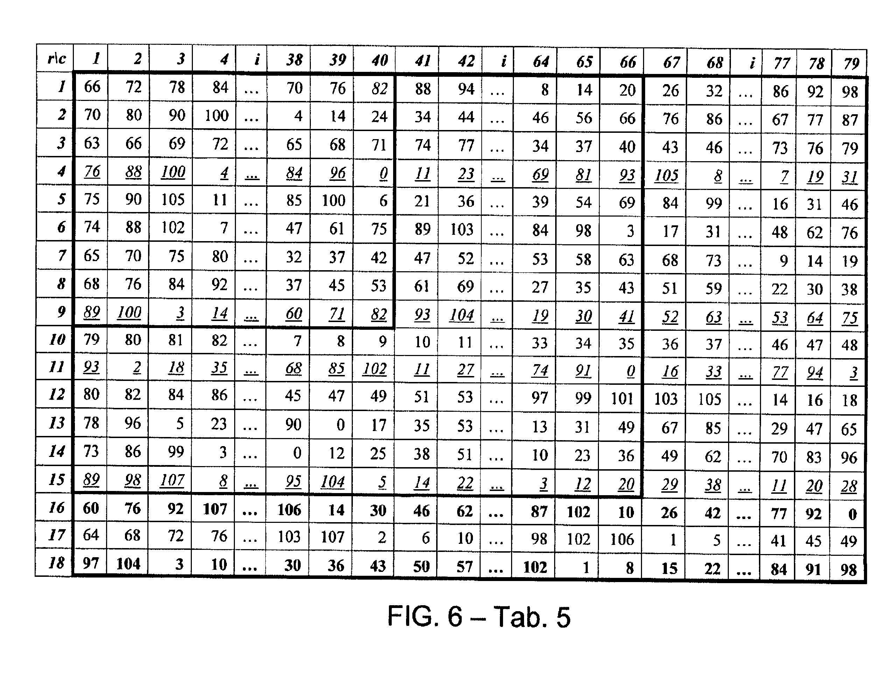

**Table 5** is shown in **figure 6,** where the only two rows **16** and **18,** highlighted in bold, have been modified and these rows are the twos dedicated to the LDPC codeword $n_0$ = 10368. Rows *4* and *9*, previously processed for codeword $n_3$ and rows *11* and *15*, previously processed for codeword $n_1$, are indicated in underlined italic.

In addition to the sub-tables $\mathbf{T}_{\text{exp}-3}$ and $\mathbf{T}_{\text{exp}-1}$, **Table 5** includes a thick-line framed table $\mathbf{T}_{\text{exp}-0}$ overlapped to $\mathbf{T}_{\text{exp}-3}$ and $\mathbf{T}_{\text{exp}-1}$, and including 1422 elements delimited by the $r_{b\_0}$ = 18 rows and the $k_{b\_0}$ + 1 = 79 columns of **Table 5.**

**Table 5** shows a multi-length table comprised of a nested structure of sub-tables, wherein sub-tables generated by larger codewords (lower value of integer $x$) include sub-tables generated by shorter codewords (higher value of integer $x$).

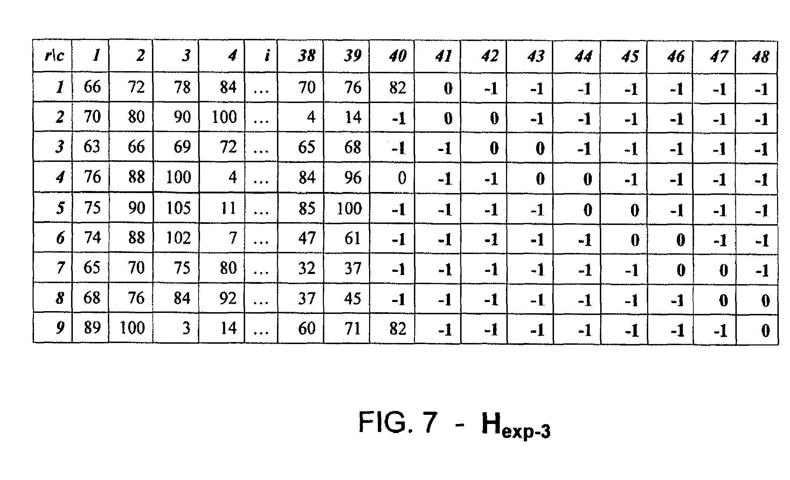

All depicted sub-tables begin from the first element of **Table 2,** but this doesn't constitute a limitation for the invention, since other nested structure are possible. **Figure 7** shows a nested structure of sub-tables in accordance with the method described (for sake of simplicity the numerical values are not indicated).

*__Exemplary completion of the exponent matrix__* $\mathbf{H}_{exp\_3}$

Now let us consider the multi-length exponent **Table 5** of **figure 6** for LDPC codewords $n_3$ = 5184, $n_1$ = 8640, $n_0$ = 10368, and let us show as to extract the random sub matrix and semi-deterministic column vector $\mathbf{C}v_{\_3}$ for implementing the exponent matrix $\mathbf{H}_{exp\_3}$ for LDPC code with rate $R$ = 13/16 and codeword length $n_3$ = 5184.

As said before, the exponent matrix for LDPC codeword length $n_3$ = 5184 has sizes $r_{b\text{-}3} \cdot n_{b\_3}$, where $rb_{\_3}$ = 9 and $n_{b\_3}$ = 48. The corresponding base model exponent table has sizes $r_b \cdot (k_b + 1)$. Integers $k_b$ = 78 and $r_b$ = 18 correspond to the block structured information sequence and the block structured parity sequence of the LDPC codeword $n_0$, respectively.

The complete exponent matrix $\mathbf{H}_{exp-3}$ for LDPC code with rate $R$ = 13/16 and codeword of length $n_3$ = 5184 is obtained starting from the multi-length exponent **Table 5** of **figure 6** in two alternative ways:

- a first modality (preservative of the multi-length Table 5 for adaptive MCS) consists of copying all 360 elements of sub-table $\mathbf{T}_{exp-3}$ delimited in **Table 5** by the first 9 rows and the first 40 columns, into a processing memory reserved to the exponent matrix $\mathbf{H}_{exp-3}$, and then joining adjacently the deterministic matrix highlighted in bold in the exponent matrix depicted in **figure 7.**
- A second modality consist of eliminating from **Table 5** $r_b$ - $r_{b\_3}$ = 18-9 = 9 rows of higher index and $(k_b + 1)$ - $(k_{b\_3}$ + 1) = $k_b$ - $k_{b\_3}$ = 78-39 = 39 columns of higher index, in order tot obtain the sub-table $\mathbf{T}_{exp-3}$, storing it in memory and then joining adjacently the deterministic matrix highlighted in bold in the exponent matrix depicted in **figure 7.**

The wording "joining adjacently" shall be intended as operating onto the processing memory reserved to the exponent matrix, and already containing sub-table $\mathbf{T}_{exp-3}$, as in the following:

- joining to the stored sub-table $\mathbf{T}_{exp-3}$ a contiguous deterministic matrix of size $(r_{b\_3} \times (r_{b-3}$ - 1)) elements, in which all elements along the two left diagonals are filled with an element ("**0**") indicating the identity matrix, and the remaining elements are filled with an element ("**-1**") indicating the null matrix;

- replacing with an element ("**-1**") indicating the null matrix the value of all elements in the last column of stored sub-table $\mathbf{T}_{exp\_3}$ different than the previously processed elements located at the positions (1,40), (4,40), (9,40).

The complete exponent matrixes for other codeword lengths shall be derived from the respective sub-tables accordingly.

The exponent matrix $\mathbf{H}_{exp-3}$ opportunely multiplied (masked) by the seed matrix, and then expanded with the permutation matrixes of spreading factor $Z_0$ =108, produces the parity-check binary matrix $\mathbf{H}_{r\times n}$ = $\mathbf{H}_{972\times 5184}$ which is used for implementing the LDPC codeword $n_3$ = 5184.

Although the invention has been described with particular reference to a preferred embodiment, it will be evident to those skilled in the art, that the present invention is not limited thereto, but further variations and modifications may be applied without departing from the scope of the invention as defined by the annexed claims.

## References

[Ref.1]    IEEE Std 802.16e - Air Interface for Fixed and Mobile Broadband Wireless Access Systems - 28 February 2006.
[Ref.2]    Jon G. Proakis, "DIGITAL COMMUNICATIONS", fourth edition; published by McGraw-Hill, year 2001, ISBN 0-07-232111-3.

## Used acronyms

BP          Belief Propagation

LDPC       Low Density Parity Check Code

MCS        Modulation and Coding Scheme

WiMAX      Worldwide Interoperability for Microwave Access

**Claims**

1. Method of encoding (CH-ENC) information sequences of k bits using low-density parity check code exponent matrixes, each element of which, namely the exponent, being expanded into a permutation matrix $(\mathbf{I}_{Z_f}^{[0]}, \mathbf{I}_{Z_f}^{[1]}, \mathbf{I}_{Z_f}^{[Z_f-1]})$ by a cyclic shift of the identity matrix $(\mathbf{I}_{Z_f}^{[0]})$ with a shift-size corresponding to the value of said exponent, and every parity-check exponent matrix being composed of two contiguous sub-matrixes with the same number $r_b$ of rows, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$ -1 columns and a first column vector whose elements have a value (-1) which represents the null matrix with the only exception of the first and the last element that include a same randomly selected exponent, and of a third element in a random position between the twos having a value (0) which represents the identity matrix,
the method being <u>**characterized in that**</u> includes the following steps:

> a) providing a main table (Tab.2) of $r_b$ rows and $k_b$ + 1 columns and filling it with random values included in a range of allowed exponents, starting from: the longest codeword length $n_0$, the longest information sequence $k_0$, a fixed code-rate $R = \dfrac{k_0}{n_0}$, a fixed spreading factor $Z_0$, being $n_b = \dfrac{n_0}{Z_0}$, $k_b = \dfrac{k_0}{Z_0}$, and $r_b = n_b - k_b$;
>
> b) calculating for any allowed integer x inclusive of zero: a first corresponding integer $k_{b\_x} = (k_b - c_1 x)$, a second corresponding integer $n_{b-x} = (n_b - c_2 x)$, and a third corresponding integer $r_{b\_x} = n_{b\_x} - k_{b\_x}$, being $c_1$ and $c_2$ integers such that $\dfrac{c_1}{c_2} = R$ without any common divisor, and $\cdot_{b-x}$ a subscript associated to integer x;
>
> c) for any allowed integer x, delimiting in the main table (Tab.2), starting from its initial element, a corresponding sub-table (Tab.3, Tab.4, Tab.5) of $r_{b\_x}$ consecutive rows and $k_{b\_x}$ + 1 consecutive columns, and for every sub-table processing modulo $Z_0$ two unprocessed rows of the main table to fulfil on the last column of the sub-table the conditions posed on the first column vector of said composite sub-matrix;
>
> d) for any allowed integer x and a corresponding codeword of length $n_{b\_x}$, providing an exponent matrix ($\mathbf{H}_{\text{exp-3}}$) including the sub-table (Tab.3) for that x plus a deterministic sub-matrix for that x of $r_{b\_x}$ rows and of $r_{b\_x}$ - 1 columns, and replacing the unprocessed elements of the last column of said sub-table (Tab.3) with a conventional value (-1) which corresponds to the null matrix.

2. Method of decoding (CH-DEC) low-density parity check codewords by means of parity-check exponent matrixes, each element of which, namely the exponent, being expanded into a permutation matrix $(\mathbf{I}_{Z_f}^{[0]}, \mathbf{I}_{Z_f}^{[1]}, \mathbf{I}_{Z_f}^{[Z_f-1]})$ by a cyclic shift of the identity matrix $(\mathbf{I}_{Z_f}^{[0]})$ with a shift-size corresponding to the value of said exponent, and every parity-check exponent matrix being composed of two contiguous sub-matrixes with the same number $r_b$ of rows, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$-1 columns and a first column vector whose elements have a value (-1) which represents the null matrix with the only exception of the first and the last elements that include a same randomly selected exponent, and of a third element in a random position between the twos having a value (0) which represents the identity matrix,
the method being <u>**characterized in that**</u> includes the following steps:

> a) providing a main table (Tab.2) of $r_b$ rows and $k_b$ + 1 columns and filling it with random values included in a range of allowed exponents, starting from: the longest codeword length $n_0$, the longest information sequence $k_0$, a fixed code-rate $R = \dfrac{k_0}{n_0}$, the highest spreading factor $Z_0$, being $n_b = \dfrac{n_0}{Z_0}$, $k_b = \dfrac{k_0}{Z_0}$, and $r_b = n_b - k_b$;

b) calculating for any allowed integer $x$ inclusive of zero: a first corresponding integer $k_{b\_x} = (k_b - c_1 x)$, a second corresponding integer $n_{b-x} = (n_b - c_2 x)$, and a third corresponding integer $r_{b\_x} = n_{b-x} - k_{b\_x}$, being $c_1$ and $c_2$ integers such that

$$\frac{c_1}{c_2} = R$$ without any common divisor, and $\cdot_{b-x}$ a subscript associated to integer $x$; $c_2$

c) for any allowed integer $x$, delimiting in the main table (Tab.2), starting from its initial element, a corresponding sub-table (Tab.3, Tab.4, Tab.5) of $r_{b\_x}$ consecutive rows and $k_{b\_x} + 1$ consecutive columns, and for every sub-table processing modulo $Z_0$ two unprocessed rows of the main table to fulfil on the last column of the sub-table the conditions posed on the first column vector of said composite sub-matrix;

d) for any allowed integer $x$ and a corresponding codeword of length $n_{b\_x}$, providing an exponent matrix ($\mathbf{H}_{\text{exp-3}}$) including the sub-table (Tab.3) for that $x$ plus a deterministic sub-matrix for that $x$ of $r_{b\_x}$ rows and of $r_{b\_x} - 1$ columns, and replacing the unprocessed elements of the last column of said sub-table with a conventional value (-1) which corresponds to the null matrix.

3.  The method of claim 1 or 2, **characterized in that** the processing at step c) includes:

   c1) choosing a first unprocessed row having index $r_{b\_x}$;
   c2) choosing a second unprocessed row randomly among the one having index $r_{b\_x}$ and 1, both excluded, and the remaining unprocessed rows;
   c3) obtaining a first exponent by subtracting modulus $Z_0$ the element of said first unprocessed row positioned in column $k_{b\_x} + 1$ from the element positioned in the first row and in column $k_{b\_x} + 1$;
   c4) adding modulus $Z_0$ said first exponent to every elements of said first unprocessed row;
   c5) obtaining a second exponent by subtracting modulus $Z_0$ the element of said second unprocessed row positioned in column $k_{b\_x} + 1$ from the integer zero;
   c6) adding modulus $Z_0$ said second exponent to every elements of said second unprocessed row.

4.  The method of claim 1 or 2, **characterized in that** said sub-tables (Tab.3, Tab.4, Tab.5) constitute a nested structure within the main table (Tab.2).

5.  The method of claim 1 or 2, **characterized in that** for $x = 0$ the corresponding sub-table (Tab.5) is sized as the main table to comply with full-length codewords.

6.  The method of claim 1 or 2, **characterized in that** step d) leaves unchanged the main table (Tab.2).as processed.

7.  A system (FIG.1) having means (CH-ENC, CH-DEC) for performing the steps of the method according to any claim from 1 to 6.

**Patentansprüche**

1.  Verfahren zum Codieren (CH-ENC) von Informationssequenzen von $k$ Bit unter Verwendung von Codeexponentenmatrizen des Low-Density Parity Check, wovon jedes Element, nämlich der Exponent, durch eine zyklische Verschiebung der Identitätsmatrix $\left(\mathbf{I}_{z_f}^{[0]}\right)$ mit einer dem Wert des Exponenten entsprechenden Verschiebungsgröße in eine Permutationsmatrix

$\left(\mathbf{I}_{z_f}^{[0]}, \mathbf{I}_{z_f}^{[1]}, \mathbf{I}_{z_f}^{[z_f-1]}\right)$ entwickelt wird und jede Paritätsprüf-Exponentenmatrix aus zwei zusammenhängenden Teilmatrizen mit derselben Anzahl $r_b$ von Zeilen zusammengesetzt ist, wobei eine erste eine Zufallsteilmatrix von $k_b$ Spalten ist, die einen Block von Informationsbit berücksichtigt, und eine zweite eine zusammengesetzte Teilmatrix von $r_b$ Spalten ist, die Redundanzbit berücksichtigt, wobei die zusammengesetzte Teilmatrix einen deterministischen Teil von $r_b - 1$ Spalten und einen ersten Spaltenvektor enthält, wobei die Elemente davon einen Wert (-1) aufweisen, wodurch die Nullmatrix repräsentiert wird, mit der einzigen Ausnahme des ersten und des letzten Elements, die einen selben zufällig ausgewählten Exponenten enthalten, und eines dritten Elements an einer Zufallsposition zwischen den zweien mit einem Wert (0), wodurch die Identitätsmatrix repräsentiert wird, wobei das Verfahren **dadurch gekennzeichnet ist, dass** es die folgenden Schritte umfasst:

a) Bereitstellen einer Haupttabelle (Tab. 2) von $r_b$ Zeilen und $k_b$+1 Spalten und Füllen dieser mit Zufallswerten, die in einem Bereich erlaubter Exponenten enthalten sind, beginnend bei: der längsten Codewortlänge $n_0$, der längsten Informationssequenz $k_0$, einer festen Coderate $R = \dfrac{k_0}{n_0}$, einem festen Spreizfaktor $Z_0$, nämlich

$$n_b = \frac{n_0}{Z_0}, \qquad k_b = \frac{k_0}{Z_0} \text{ und } r_b = n_b - k_b;$$

b) Berechnen von Folgendem für jede erlaubte ganze Zahl $x$ einschließlich null: einer ersten entsprechenden ganzen Zahl $k_{b\_x} = (k_b - c_1 x)$, einer zweiten entsprechenden ganzen Zahl $n_{b\text{-}x} = (n_b - c_2 x)$ und einer dritten entsprechenden ganzen Zahl $r_{b\_x} = n_{b\_x} - k_{b\_x}$, wobei $c_1$ und $c_2$ ganze Zahlen dergestalt, dass $\dfrac{c_1}{c_2} = R$ ohne jeden gemeinsamen Teiler ist, und $_{b\text{-}x}$ ein mit der ganzen Zahl $x$ assoziierter Subskript sind;

c) für jede erlaubte ganze Zahl $x$ Abgrenzen einer entsprechenden Subtabelle (Tab. 3, Tab. 4, Tab. 5) von $r_{b\_x}$ aufeinanderfolgenden Zeilen und $k_{b\_x}$+1 aufeinanderfolgenden Spalten in der Haupttabelle (Tab. 2) beginnend von ihrem Anfangselement, und für jede Subtabelle Verarbeiten von zwei unverarbeiteten Zeilen der Haupttabelle modulo $Z_0$, um an der letzten Spalte der Subtabelle die an den ersten Spaltenvektor der zusammengesetzten Teilmatrix auferlegten Bedingungen zu erfüllen;

d) für jede erlaubte ganze Zahl $x$ und ein entsprechendes Codewort der Länge $n_{b\_x}$ Bereitstellen einer Exponentenmatrix ($\mathbf{H}_{\text{exp-3}}$), die die Subtabelle (Tab. 3) für dieses $x$ plus eine deterministische Teilmatrix für dieses $x$ von $r_{b\_x}$ Zeilen und von $r_{b\_x}$-1 Spalten enthält, und Ersetzen der unverarbeiteten Elemente der letzten Spalte der Subtabelle (Tab. 3) mit einem herkömmlichen Wert (-1), der der Nullmatrix entspricht.

2. Verfahren zum Decodieren (CH-DEC) von Codewörtern des Low-Density Parity Check mittels Paritätsprüf-Exponentenmatrizen, wovon jedes Element, nämlich der Exponent, durch eine zyklische Verschiebung der Identitätsmatrix $\left(\mathbf{I}_{Z_f}^{[0]}\right)$ mit einer dem Wert des Exponenten entsprechenden Verschiebungsgröße in eine Permutationsmatrix $\left(\mathbf{I}_{Z_f}^{[0]}, \mathbf{I}_{Z_f}^{[1]}, \mathbf{I}_{Z_f}^{[Z_f-1]}\right)$ entwickelt wird und jede Paritätsprüf-Exponentenmatrix aus zwei zusammenhängenden Teilmatrizen mit derselben Anzahl $r_b$ von Zeilen zusammengesetzt ist, wobei eine erste eine ZufallsTeilmatrix von $k_b$ Spalten ist, die einen Block von Informationsbit berücksichtigt, und eine zweite eine zusammengesetzte Teilmatrix von $r_b$ Spalten ist, die Redundanzbit berücksichtigt, wobei die zusammengesetzte Teilmatrix einen deterministischen Teil von $r_{b\text{-}1}$ Spalten und einen ersten Spaltenvektor enthält, wobei die Elemente davon einen Wert (-1) aufweisen, wodurch die Nullmatrix repräsentiert wird, mit der einzigen Ausnahme des ersten und des letzten Elements, die einen selben zufällig ausgewählten Exponenten enthalten, und eines dritten Elements an einer Zufallsposition zwischen den zweien mit einem Wert (0), wodurch die Identitätsmatrix repräsentiert wird, wobei das Verfahren **<u>dadurch gekennzeichnet ist, dass</u>** es die folgenden Schritte umfasst:

a) Bereitstellen einer Haupttabelle (Tab. 2) von $r_b$ Zeilen und $k_b$+1 Spalten und Füllen dieser mit Zufallswerten, die in einem Bereich erlaubter Exponenten enthalten sind, beginnend bei: der längsten Codewortlänge $n_0$, der längsten Informationssequenz $k_0$, einer festen Coderate $R = \dfrac{k_0}{n_0}$, dem höchsten Spreizfaktor $Z_0$, nämlich

$$n_b = \frac{n_0}{Z_0}, \qquad k_b = \frac{k_0}{Z_0} \text{ und } r_b = n_b - k_b;$$

b) Berechnen von Folgendem für jede erlaubte ganze Zahl $x$ einschließlich null: einer ersten entsprechenden ganzen Zahl $k_{b\_x} = (k_b - c_1 x)$, einer zweiten entsprechenden ganzen Zahl $n_{b\text{-}x} = (n_b - c_2 x)$ und einer dritten entsprechenden ganzen Zahl $r_{b\_x} = n_{b\_x} - k_{b\_x}$, wobei $c_1$ und $c_2$ ganze Zahlen dergestalt, dass $\dfrac{c_1}{c_2} = R$ ohne jeden gemeinsamen Teiler ist, und $_{b\text{-}x}$ ein mit der ganzen Zahl $x$ assoziierter Subskript sind;

c) für jede erlaubte ganze Zahl $x$ Abgrenzen einer entsprechenden Subtabelle (Tab. 3, Tab. 4, Tab. 5) von $r_{b\_x}$

aufeinanderfolgenden Zeilen und $k_{b\_x}$+1 aufeinanderfolgenden Spalten in der Haupttabelle (Tab. 2) beginnend von ihrem Anfangselement, und für jede Subtabelle Verarbeiten von zwei unverarbeiteten Zeilen der Haupttabelle modulo $Z_0$, um an der letzten Spalte der Subtabelle die an den ersten Spaltenvektor der zusammengesetzten Teilmatrix auferlegten Bedingungen zu erfüllen;

d) für jede erlaubte ganze Zahl $x$ und ein entsprechendes Codewort der Länge $n_{b\_x}$ Bereitstellen einer Exponentenmatrix ($\mathbf{H}_{exp}$-3), die die Subtabelle (Tab. 3) für dieses $x$ plus eine deterministische Teilmatrix für dieses $x$ von $r_{b\_x}$ Zeilen und von $r_{b-x}$-1 Spalten enthält, und Ersetzen der unverarbeiteten Elemente der letzten Spalte der Subtabelle mit einem herkömmlichen Wert (-1), der der Nullmatrix entspricht.

**3.** Verfahren nach Anspruch 1 oder 2, **dadurch gekennzeichnet, dass** die Verarbeitung im Schritt c) Folgendes umfasst:

c1) Wählen einer ersten unverarbeiteten Zeile mit dem Index $r_{b\_x}$;
c2) zufälliges Wählen einer zweiten unverarbeiteten Zeile aus der mit dem Index $r_{b-x}$ und 1, beides ausgeschlossen, und den verbleibenden unverarbeiteten Zeilen;
c3) Erhalten eines ersten Exponenten durch Subtrahieren des Elements der ersten unverarbeiteten Zeile mit der Position in Spalte $k_{b\_x}$+1 von dem Element mit der Position in der ersten Zeile und in Spalte $k_{b\_x}$+1 modulus $Z_0$;
c4) Addieren des ersten Exponenten zu allen Elementen der ersten unverarbeiteten Zeile modulus $Z_0$;
c5) Erhalten eines zweiten Exponenten durch Subtrahieren des Elements der zweiten unverarbeiteten Zeile mit der Position in Spalte $k_{b\_x}$+1 von der ganzen Zahl null modulus $Z_0$;
c6) Addieren des zweiten Exponenten zu allen Elementen der zweiten unverarbeiteten Zeile modulus $Z_0$.

**4.** Verfahren nach Anspruch 1 oder 2, **dadurch gekennzeichnet, dass** die Subtabellen (Tab. 3, Tab. 4, Tab. 5) eine vernestete Struktur in der Haupttabelle (Tab. 2) bilden.

**5.** Verfahren nach Anspruch 1 oder 2, **dadurch gekennzeichnet, dass** für $x$ = 0 die entsprechende Subtabelle (Tab. 5) als die Haupttabelle bemessen wird, um Codewörtern voller Länge zu genügen.

**6.** Verfahren nach Anspruch 1 oder 2, **dadurch gekennzeichnet, dass** Schritt d) die verarbeitete Haupttabelle (Tab. 2) unverändert lässt.

**7.** System (FIG.1) mit Mitteln (CH-ENC, CH-DEC) zum Ausführen der Schritte des Verfahrens nach einem der Ansprüche 1 bis 6.

## Revendications

**1.** Un procédé de codage (CH-ENC) de séquences d'information de k bits au moyen de matrices d'exposants de code de contrôle de parité à faible densité, dont chaque élément, à savoir l'exposant, est développé en une matrice de permutation ($\mathbf{I}_{Z_f}^{[0]}, \mathbf{I}_{Z_f}^{[1]}, \mathbf{I}_{Z_f}^{[Z_f-1]}$) par un décalage cyclique de la matrice d'identités ($\mathbf{I}_{Z_f}^{[0]}$) avec un degré de décalage correspondant à la valeur dudit exposant, et chaque matrice d'exposants de contrôle de parité est composée de deux sous-matrices contiguës avec le même nombre $r_b$ de lignes, une première sous-matrice étant une sous-matrice aléatoire de $k_b$ colonnes qui représente un bloc de bits d'information et une deuxième sous-matrice étant une sous-matrice composite de $r_b$ colonnes qui représente des bits de redondance, la sous-matrice composite comprenant une partie déterministe de $r_b$-1 colonnes et un premier vecteur de colonne dont les éléments ont une valeur (-1) qui représente la matrice zéro à la seule exception du premier et du dernier élément qui comprennent un même exposant sélectionné de manière aléatoire, et d'un troisième élément dans une position aléatoire entre les deux ayant une valeur (0) qui représente la matrice d'identités,
le procédé <u>étant</u> **caractérisé en ce qu'**il comprend les opérations suivantes :

a) la fourniture d'une table principale (Tab.2) de $r_b$ lignes et $k_b$+1 colonnes et son remplissage avec des valeurs aléatoires comprises dans une plage d'exposants autorisés, en partant de : la longueur de mot de code la plus grande $n_0$, la séquence d'information la plus longue $k_0$, un taux de code fixe $R = \dfrac{k_0}{n_0}$, un facteur d'étalement

fixe $Z_0$, étant $n_b = \frac{n_0}{Z_0}$, $k_b = \frac{k_0}{Z_0}$, et $r_b = n_b - k_b$,

b) le calcul, pour tout entier autorisé $x$ zéro inclus : d'un premier entier correspondant $k_{b\_x} = (k_b - c_1 x)$, d'un deuxième entier correspondant $n_{b-x} = (n_b - c_2 x)$, et d'un troisième entier correspondant $r_{b\_x} = n_{b\_x} - k_{b\_x}$, $c_1$ et $c_2$ étant des entiers tels que $\frac{c_1}{c_2} = R$ sans aucun diviseur commun, et $\cdot_{b-x}$ un indice bas associé à l'entier $x$,

c) pour tout entier autorisé $x$, la délimitation dans la table principale (Tab.2), en partant de son élément initial, d'une sous-table correspondante (Tab.3, Tab.4, Tab.5) de $r_{b\_x}$ lignes consécutives et $k_{b\_x}$ + 1 colonnes consécutives, et pour chaque sous-table le traitement modulo $Z_0$ de deux lignes non traitées de la table principale afin de remplir dans la dernière colonne de la sous-table les conditions posées sur le premier vecteur de colonne de ladite sous-matrice composite,

d) pour tout entier autorisé $x$ et un mot de code correspondant de longueur $n_{b\_x}$, la fourniture d'une matrice d'exposants ($H_{exp}$-3) comprenant la sous-table (Tab.3) pour cet $x$ plus une sous-matrice déterministe pour cet $x$ de $r_{b\_x}$ lignes et de $r_{b\_x}$ - 1 colonnes, et le remplacement des éléments non traités de la dernière colonne de ladite sous-table (Tab.3) par une valeur conventionnelle (-1) qui correspond à la matrice zéro.

2. Un procédé de décodage (CH-DEC) de mots de code de contrôle de parité à faible densité au moyen de matrices d'exposants de contrôle de parité, dont chaque élément, à savoir l'exposant, est développé en une matrice de permutation ($I_{Z_f}^{[0]}$, $I_{Z_f}^{[1]}$, $I_{Z_f}^{[Z_f-1]}$) par un décalage cyclique de la matrice d'identités ($I_{Z_f}^{[0]}$) avec un degré de décalage correspondant à la valeur dudit exposant, et chaque matrice d'exposants de contrôle de parité est composée de deux sous-matrices contiguës avec le même nombre $r_b$ de lignes, une première sous-matrice étant une sous-matrice aléatoire de $k_b$ colonnes qui représente un bloc de bits d'information et une deuxième sous-matrice étant une sous-matrice composite de $r_b$ colonnes qui représente des bits de redondance, la sous-matrice composite comprenant une partie déterministe de $r_b$ - 1 colonnes et un premier vecteur de colonne dont les éléments ont une valeur (-1) qui représente la matrice zéro à la seule exception du premier et du dernier éléments qui comprennent un même exposant sélectionné de manière aléatoire, et d'un troisième élément dans une position aléatoire entre les deux ayant une valeur (0) qui représente la matrice d'identités,

le procédé étant <u>**caractérisé en ce qu'**</u>il comprend les opérations suivantes :

a) la fourniture d'une table principale (Tab.2) de $r_b$ lignes et de $k_b$ + 1 colonnes et son remplissage avec des valeurs aléatoires comprises dans une plage d'exposants autorisés, en partant de : la longueur de mot de code la plus grande $n_0$, la séquence d'information la plus longue $k_0$, un taux de code fixe $R = \frac{k_0}{n_0}$, le facteur d'étalement le plus élevé $Z_0$, étant $n_b = \frac{n_0}{Z_0}$, $k_b = \frac{k_0}{Z_0}$, et $r_b - n_b - k_b$,

b) le calcul, pour tout entier autorisé x zéro inclus : d'un premier entier correspondant $k_{b-x} = (k_b - c_1 x)$, d'un deuxième entier correspondant $n_{b-x} - (n_b - c_2 x)$, et d'un troisième entier correspondant $r_{b\_x} = n_{b\_x} - k_{b\_x}$, $c_1$ et $c_2$ étant des entiers tels que $\frac{c_1}{c_2} = R$ sans aucun diviseur commun, et $\bullet_{b-x}$ un indice bas associé à l'entier $x$,

c) pour tout entier autorisé $x$, la délimitation dans la table principale (Tab.2), en partant de son élément initial, d'une sous-table correspondante (Tab.3, Tab.4, Tab.5) de $r_{b\_x}$ lignes consécutives et $k_{b\_x}$ + 1 colonnes consécutives, et pour chaque sous-table le traitement modulo $Z_0$ de deux lignes non traitées de la table principale afin de remplir dans la dernière colonne de la sous-table les conditions posées sur le premier vecteur de colonne de ladite sous-matrice composite,

d) pour tout entier autorisé $x$ et un mot de code correspondant de longueur $n_{b\_x}$, la fourniture d'une matrice d'exposants ($H_{exp-3}$) comprenant la sous-table (Tab.3) pour cet x plus une sous-matrice déterministe pour cet $x$ de $r_{b\_x}$ lignes et de $r_{b-x}$ -1 colonnes, et le remplacement des éléments non traités de la dernière colonne de ladite sous-table par une valeur conventionnelle (-1) qui correspond à la matrice zéro.

3. Le procédé selon la revendication 1 ou 2, **caractérisé en ce que** le traitement à l'opération c) comprend :

c1) le choix d'une première ligne non traitée possédant l'indice $r_{b\_x}$,
c2) le choix d'une deuxième ligne non traitée de manière aléatoire parmi celles possédant l'indice $r_{b-x}$ et 1, les deux exclus, et les lignes non traitées restantes,

c3) l'obtention d'un premier exposant par la soustraction modulo $Z_0$ de l'élément de ladite première ligne non traitée positionnée dans la colonne $k_{b\_x}$ + 1 de l'élément positionné dans la première ligne et dans la colonne $k_{b\_x}$ + 1,

c4) l'ajout modulo $Z_0$ dudit premier exposant à tous les éléments de ladite première ligne non traitée,

c5) l'obtention d'un deuxième exposant par la soustraction modulo $Z_0$ de l'élément de ladite deuxième ligne non traitée positionné dans la colonne $k_{b\_x}$ +1 de l'entier zéro,

c6) l'ajout modulo $Z_0$ dudit deuxième exposant à tous les éléments de ladite deuxième ligne non traitée.

4. Le procédé selon la revendication 1 ou 2, **caractérisé en ce que** lesdites sous-tables (Tab.3, Tab.4, Tab.5) constituent une structure imbriquée à l'intérieur de la table principale (Tab.2).

5. Le procédé selon la revendication 1 ou 2, **caractérisé en ce que** pour x = 0 la sous-table correspondante (Tab.5) est dimensionnée comme la table principale de façon à se conformer à des mots de code de longueur complète.

6. Le procédé selon la revendication 1 ou 2, **caractérisé en ce que** l'opération d) laisse inchangée la table principale (Tab.2) telle que traitée.

7. Un système (FIG. 1) possédant un moyen (CH-ENC, CH-DEC) d'exécuter les opérations du procédé selon l'une quelconque des revendications 1 à 6.

FIG. 1

EP 2 211 470 B1

$$\mathbf{I}_{z_f}^{[0]} = \begin{bmatrix} 0 & 0 & 0 & 0 & \cdots & 0 & 0 & 1 \\ 0 & 0 & 0 & 0 & \cdots & 0 & 1 & 0 \\ 0 & 0 & 0 & 0 & \cdots & 1 & 0 & 0 \\ \cdot & \cdot & \cdot & \cdot & \cdots & \cdot & \cdot & \cdot \\ 0 & 0 & 0 & 1 & \cdots & 0 & 0 & 0 \\ 0 & 0 & 1 & 0 & \cdots & 0 & 0 & 0 \\ 0 & 1 & 0 & 0 & \cdots & 0 & 0 & 0 \\ 1 & 0 & 0 & 0 & \cdots & 0 & 0 & 0 \end{bmatrix}$$

$$\mathbf{I}_{z_f}^{[z_f-1]} = \begin{bmatrix} 1 & 0 & 0 & 0 & 0 & \cdots & 0 & 0 \\ 0 & 0 & 0 & 0 & 0 & \cdots & 0 & 1 \\ 0 & 0 & 0 & 0 & 0 & \cdots & 1 & 0 \\ \cdot & \cdot & \cdot & \cdot & \cdot & \cdots & \cdot & \cdot \\ 0 & 0 & 0 & 0 & 1 & \cdots & 0 & 0 \\ 0 & 0 & 0 & 1 & 0 & \cdots & 0 & 0 \\ 0 & 0 & 1 & 0 & 0 & \cdots & 0 & 0 \\ 0 & 1 & 0 & 0 & 0 & \cdots & 0 & 0 \end{bmatrix}$$

$$\mathbf{I}_{z_f}^{[-1]} = \begin{bmatrix} 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \\ \cdot & \cdot & \cdot & \cdot & \cdots & \cdot & \cdot & \cdot \\ 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \end{bmatrix}$$

$$\mathbf{I}_{z_f}^{[1]} = \begin{bmatrix} 0 & 0 & 0 & \cdots & 0 & 0 & 1 & 0 \\ 0 & 0 & 0 & \cdots & 0 & 1 & 0 & 0 \\ 0 & 0 & 0 & \cdots & 1 & 0 & 0 & 0 \\ \cdot & \cdot & \cdot & \cdots & \cdot & \cdot & \cdot & \cdot \\ 0 & 0 & 1 & \cdots & 0 & 0 & 0 & 0 \\ 0 & 1 & 0 & \cdots & 0 & 0 & 0 & 0 \\ 1 & 0 & 0 & \cdots & 0 & 0 & 0 & 0 \\ 0 & 0 & 0 & \cdots & 0 & 0 & 0 & 1 \end{bmatrix}$$

FIG. 2

| r\c | 1 | 2 | 3 | 4 | i | 38 | 39 | 40 | 41 | 42 | i | 64 | 65 | 66 | 67 | 68 | i | 77 | 78 | 79 |
|---|---|---|---|---|---|---|---|---|---|---|---|---|---|---|---|---|---|---|---|---|
| 1 | 66 | 72 | 78 | 84 | ... | 70 | 76 | 82 | 88 | 94 | ... | 8 | 14 | 20 | 26 | 32 | ... | 86 | 92 | 98 |
| 2 | 70 | 80 | 90 | 100 | ... | 4 | 14 | 24 | 34 | 44 | ... | 46 | 56 | 66 | 76 | 86 | ... | 67 | 77 | 87 |
| 3 | 63 | 66 | 69 | 72 | ... | 65 | 68 | 71 | 74 | 77 | ... | 34 | 37 | 40 | 43 | 46 | ... | 73 | 76 | 79 |
| 4 | 72 | 84 | 96 | 0 | ... | 80 | 92 | 104 | 7 | 19 | ... | 65 | 77 | 89 | 101 | 4 | ... | 3 | 15 | 27 |
| 5 | 75 | 90 | 105 | 11 | ... | 85 | 100 | 6 | 21 | 36 | ... | 39 | 54 | 69 | 84 | 99 | ... | 16 | 31 | 46 |
| 6 | 74 | 88 | 102 | 7 | ... | 47 | 61 | 75 | 89 | 103 | ... | 84 | 98 | 3 | 17 | 31 | ... | 48 | 62 | 76 |
| 7 | 65 | 70 | 75 | 80 | ... | 32 | 37 | 42 | 47 | 52 | ... | 53 | 58 | 63 | 68 | 73 | ... | 9 | 14 | 19 |
| 8 | 68 | 76 | 84 | 92 | ... | 37 | 45 | 53 | 61 | 69 | ... | 27 | 35 | 43 | 51 | 59 | ... | 22 | 30 | 38 |
| 9 | 71 | 82 | 93 | 104 | ... | 42 | 53 | 64 | 75 | 86 | ... | 1 | 12 | 23 | 34 | 45 | ... | 35 | 46 | 57 |
| 10 | 79 | 80 | 81 | 82 | ... | 7 | 8 | 9 | 10 | 11 | ... | 33 | 34 | 35 | 36 | 37 | ... | 46 | 47 | 48 |
| 11 | 77 | 94 | 2 | 19 | ... | 52 | 69 | 86 | 103 | 11 | ... | 58 | 75 | 92 | 0 | 17 | ... | 61 | 78 | 95 |
| 12 | 80 | 82 | 84 | 86 | ... | 45 | 47 | 49 | 51 | 53 | ... | 97 | 99 | 101 | 103 | 105 | ... | 14 | 16 | 18 |
| 13 | 78 | 96 | 5 | 23 | ... | 90 | 0 | 17 | 35 | 53 | ... | 13 | 31 | 49 | 67 | 85 | ... | 29 | 47 | 65 |
| 14 | 73 | 86 | 99 | 3 | ... | 0 | 12 | 25 | 38 | 51 | ... | 10 | 23 | 36 | 49 | 62 | ... | 70 | 83 | 96 |
| 15 | 69 | 78 | 87 | 96 | ... | 75 | 84 | 93 | 102 | 2 | ... | 91 | 100 | 0 | 9 | 18 | ... | 99 | 0 | 8 |
| 16 | 76 | 92 | 0 | 15 | ... | 14 | 30 | 46 | 62 | 78 | ... | 103 | 10 | 26 | 42 | 58 | ... | 93 | 0 | 16 |
| 17 | 64 | 68 | 72 | 76 | ... | 103 | 107 | 2 | 6 | 10 | ... | 98 | 102 | 106 | 1 | 5 | ... | 41 | 45 | 49 |
| 18 | 67 | 74 | 81 | 88 | ... | 0 | 6 | 13 | 20 | 27 | ... | 72 | 79 | 86 | 93 | 100 | ... | 54 | 61 | 68 |

## FIG. 3 – Tab. 2

| r\c | 1 | 2 | 3 | 4 | i | 38 | 39 | 40 | 41 | 42 | i | 64 | 65 | 66 | 67 | 68 | i | 77 | 78 | 79 |
|---|---|---|---|---|---|---|---|---|---|---|---|---|---|---|---|---|---|---|---|---|
| 1 | 66 | 72 | 78 | 84 | ... | 70 | 76 | 82 | 88 | 94 | ... | 8 | 14 | 20 | 26 | 32 | ... | 86 | 92 | 98 |
| 2 | 70 | 80 | 90 | 100 | ... | 4 | 14 | 24 | 34 | 44 | ... | 46 | 56 | 66 | 76 | 86 | ... | 67 | 77 | 87 |
| 3 | 63 | 66 | 69 | 72 | ... | 65 | 68 | 71 | 74 | 77 | ... | 34 | 37 | 40 | 43 | 46 | ... | 73 | 76 | 79 |
| 4 | 76 | 88 | 100 | 4 | ... | 84 | 96 | 0 | 11 | 23 | ... | 69 | 81 | 93 | 105 | 8 | ... | 7 | 19 | 31 |
| 5 | 75 | 90 | 105 | 11 | ... | 85 | 100 | 6 | 21 | 36 | ... | 39 | 54 | 69 | 84 | 99 | ... | 16 | 31 | 46 |
| 6 | 74 | 88 | 102 | 7 | ... | 47 | 61 | 75 | 89 | 103 | ... | 84 | 98 | 3 | 17 | 31 | ... | 48 | 62 | 76 |
| 7 | 65 | 70 | 75 | 80 | ... | 32 | 37 | 42 | 47 | 52 | ... | 53 | 58 | 63 | 68 | 73 | ... | 9 | 14 | 19 |
| 8 | 68 | 76 | 84 | 92 | ... | 37 | 45 | 53 | 61 | 69 | ... | 27 | 35 | 43 | 51 | 59 | ... | 22 | 30 | 38 |
| 9 | 89 | 100 | 3 | 14 | ... | 60 | 71 | 82 | 93 | 104 | ... | 19 | 30 | 41 | 52 | 63 | ... | 53 | 64 | 75 |
| 10 | 79 | 80 | 81 | 82 | ... | 7 | 8 | 9 | 10 | 11 | ... | 33 | 34 | 35 | 36 | 37 | ... | 46 | 47 | 48 |
| 11 | 77 | 94 | 2 | 19 | ... | 52 | 69 | 86 | 103 | 11 | ... | 58 | 75 | 92 | 0 | 17 | ... | 61 | 78 | 95 |
| 12 | 80 | 82 | 84 | 86 | ... | 45 | 47 | 49 | 51 | 53 | ... | 97 | 99 | 101 | 103 | 105 | ... | 14 | 16 | 18 |
| 13 | 78 | 96 | 5 | 23 | ... | 90 | 0 | 17 | 35 | 53 | ... | 13 | 31 | 49 | 67 | 85 | ... | 29 | 47 | 65 |
| 14 | 73 | 86 | 99 | 3 | ... | 0 | 12 | 25 | 38 | 51 | ... | 10 | 23 | 36 | 49 | 62 | ... | 70 | 83 | 96 |
| 15 | 69 | 78 | 87 | 96 | ... | 75 | 84 | 93 | 102 | 2 | ... | 91 | 100 | 0 | 9 | 18 | ... | 99 | 0 | 8 |
| 16 | 76 | 92 | 0 | 15 | ... | 14 | 30 | 46 | 62 | 78 | ... | 103 | 10 | 26 | 42 | 58 | ... | 93 | 0 | 16 |
| 17 | 64 | 68 | 72 | 76 | ... | 103 | 107 | 2 | 6 | 10 | ... | 98 | 102 | 106 | 1 | 5 | ... | 41 | 45 | 49 |
| 18 | 67 | 74 | 81 | 88 | ... | 0 | 6 | 13 | 20 | 27 | ... | 72 | 79 | 86 | 93 | 100 | ... | 54 | 61 | 68 |

FIG. 4 — Tab. 3

| r\c | 1 | 2 | 3 | 4 | i | 38 | 39 | 40 | 41 | 42 | i | 64 | 65 | 66 | 67 | 68 | i | 77 | 78 | 79 |
|---|---|---|---|---|---|---|---|---|---|---|---|---|---|---|---|---|---|---|---|---|
| 1 | 66 | 72 | 78 | 84 | ... | 70 | 76 | 82 | 88 | 94 | ... | 8 | 14 | 20 | 26 | 32 | ... | 86 | 92 | 98 |
| 2 | 70 | 80 | 90 | 100 | ... | 4 | 14 | 24 | 34 | 44 | ... | 46 | 56 | 66 | 76 | 86 | ... | 67 | 77 | 87 |
| 3 | 63 | 66 | 69 | 72 | ... | 65 | 68 | 71 | 74 | 77 | ... | 34 | 37 | 40 | 43 | 46 | ... | 73 | 76 | 79 |
| 4 | *76* | *88* | *100* | *4* | ... | *84* | *96* | *0* | *11* | *23* | ... | *69* | *81* | *93* | *105* | *8* | ... | *7* | *19* | *31* |
| 5 | 75 | 90 | 105 | 11 | ... | 85 | 100 | 6 | 21 | 36 | ... | 39 | 54 | 69 | 84 | 99 | ... | 16 | 31 | 46 |
| 6 | 74 | 88 | 102 | 7 | ... | 47 | 61 | 75 | 89 | 103 | ... | 84 | 98 | 3 | 17 | 31 | ... | 48 | 62 | 76 |
| 7 | 65 | 70 | 75 | 80 | ... | 32 | 37 | 42 | 47 | 52 | ... | 53 | 58 | 63 | 68 | 73 | ... | 9 | 14 | 19 |
| 8 | 68 | 76 | 84 | 92 | ... | 37 | 45 | 53 | 61 | 69 | ... | 27 | 35 | 43 | 51 | 59 | ... | 22 | 30 | 38 |
| 9 | *89* | *100* | *3* | *14* | ... | *60* | *71* | *82* | *93* | *104* | ... | *19* | *30* | *41* | *52* | *63* | ... | *53* | *64* | *75* |
| 10 | 79 | 80 | 81 | 82 | ... | 7 | 8 | 9 | 10 | 11 | ... | 33 | 34 | 35 | 36 | 37 | ... | 46 | 47 | 48 |
| 11 | 93 | 2 | 18 | 35 | ... | 68 | 85 | 102 | 11 | 27 | ... | 74 | 91 | 0 | 16 | 33 | ... | 77 | 94 | 3 |
| 12 | 80 | 82 | 84 | 86 | ... | 45 | 47 | 49 | 51 | 53 | ... | 97 | 99 | 101 | 103 | 105 | ... | 14 | 16 | 18 |
| 13 | 78 | 96 | 5 | 23 | ... | 90 | 0 | 17 | 35 | 53 | ... | 13 | 31 | 49 | 67 | 85 | ... | 29 | 47 | 65 |
| 14 | 73 | 86 | 99 | 3 | ... | 0 | 12 | 25 | 38 | 51 | ... | 10 | 23 | 36 | 49 | 62 | ... | 70 | 83 | 96 |
| 15 | 89 | 98 | 107 | 8 | ... | 95 | 104 | 5 | 14 | 22 | ... | 3 | 12 | 20 | 29 | 38 | ... | 11 | 20 | 28 |
| 16 | 76 | 92 | 0 | 15 | ... | 14 | 30 | 46 | 62 | 78 | ... | 103 | 10 | 26 | 42 | 58 | ... | 93 | 0 | 16 |
| 17 | 64 | 68 | 72 | 76 | ... | 103 | 107 | 2 | 6 | 10 | ... | 98 | 102 | 106 | 1 | 5 | ... | 41 | 45 | 49 |
| 18 | 67 | 74 | 81 | 88 | ... | 0 | 6 | 13 | 20 | 27 | ... | 72 | 79 | 86 | 93 | 100 | ... | 54 | 61 | 68 |

FIG. 5 – Tab. 4

EP 2 211 470 B1

| r\c | 1 | 2 | 3 | 4 | i | 38 | 39 | 40 | 41 | 42 | i | 64 | 65 | 66 | 67 | 68 | i | 77 | 78 | 79 |
|---|---|---|---|---|---|---|---|---|---|---|---|---|---|---|---|---|---|---|---|---|
| 1 | 66 | 72 | 78 | 84 | ... | 70 | 76 | 82 | 88 | 94 | ... | 8 | 14 | 20 | 26 | 32 | ... | 86 | 92 | 98 |
| 2 | 70 | 80 | 90 | 100 | ... | 4 | 14 | 24 | 34 | 44 | ... | 46 | 56 | 66 | 76 | 86 | ... | 67 | 77 | 87 |
| 3 | 63 | 66 | 69 | 72 | ... | 65 | 68 | 71 | 74 | 77 | ... | 34 | 37 | 40 | 43 | 46 | ... | 73 | 76 | 79 |
| 4 | 76 | 88 | 100 | 4 | ... | 84 | 96 | 0 | 11 | 23 | ... | 69 | 81 | 93 | 105 | 8 | ... | 7 | 19 | 31 |
| 5 | 75 | 90 | 105 | 11 | ... | 85 | 100 | 6 | 21 | 36 | ... | 39 | 54 | 69 | 84 | 99 | ... | 16 | 31 | 46 |
| 6 | 74 | 88 | 102 | 7 | ... | 47 | 61 | 75 | 89 | 103 | ... | 84 | 98 | 3 | 17 | 31 | ... | 48 | 62 | 76 |
| 7 | 65 | 70 | 75 | 80 | ... | 32 | 37 | 42 | 47 | 52 | ... | 53 | 58 | 63 | 68 | 73 | ... | 9 | 14 | 19 |
| 8 | 68 | 76 | 84 | 92 | ... | 37 | 45 | 53 | 61 | 69 | ... | 27 | 35 | 43 | 51 | 59 | ... | 22 | 30 | 38 |
| 9 | 89 | 100 | 3 | 14 | ... | 60 | 71 | 82 | 93 | 104 | ... | 19 | 30 | 41 | 52 | 63 | ... | 53 | 64 | 75 |
| 10 | 79 | 80 | 81 | 82 | ... | 7 | 8 | 9 | 10 | 11 | ... | 33 | 34 | 35 | 36 | 37 | ... | 46 | 47 | 48 |
| 11 | 93 | 2 | 18 | 35 | ... | 68 | 85 | 102 | 11 | 27 | ... | 74 | 91 | 0 | 16 | 33 | ... | 77 | 94 | 3 |
| 12 | 80 | 82 | 84 | 86 | ... | 45 | 47 | 49 | 51 | 53 | ... | 97 | 99 | 101 | 103 | 105 | ... | 14 | 16 | 18 |
| 13 | 78 | 96 | 5 | 23 | ... | 90 | 0 | 17 | 35 | 53 | ... | 13 | 31 | 49 | 67 | 85 | ... | 29 | 47 | 65 |
| 14 | 73 | 86 | 99 | 3 | ... | 0 | 12 | 25 | 38 | 51 | ... | 10 | 23 | 36 | 49 | 62 | ... | 70 | 83 | 96 |
| 15 | 89 | 98 | 107 | 8 | ... | 95 | 104 | 5 | 14 | 22 | ... | 3 | 12 | 20 | 29 | 38 | ... | 11 | 20 | 28 |
| 16 | 60 | 76 | 92 | 107 | ... | 106 | 14 | 30 | 46 | 62 | ... | 87 | 102 | 10 | 26 | 42 | ... | 77 | 92 | 0 |
| 17 | 64 | 68 | 72 | 76 | ... | 103 | 107 | 2 | 6 | 10 | ... | 98 | 102 | 106 | 1 | 5 | ... | 41 | 45 | 49 |
| 18 | 97 | 104 | 3 | 10 | ... | 30 | 36 | 43 | 50 | 57 | ... | 102 | 1 | 8 | 15 | 22 | ... | 84 | 91 | 98 |

FIG. 6 – Tab. 5

| r\c | 1 | 2 | 3 | 4 | i | 38 | 39 | 40 | 41 | 42 | 43 | 44 | 45 | 46 | 47 | 48 |
|---|---|---|---|---|---|---|---|---|---|---|---|---|---|---|---|---|
| 1 | 66 | 72 | 78 | 84 | ... | 70 | 76 | 82 | 0 | -1 | -1 | -1 | -1 | -1 | -1 | -1 |
| 2 | 70 | 80 | 90 | 100 | ... | 4 | 14 | -1 | 0 | 0 | -1 | -1 | -1 | -1 | -1 | -1 |
| 3 | 63 | 66 | 69 | 72 | ... | 65 | 68 | -1 | -1 | 0 | 0 | -1 | -1 | -1 | -1 | -1 |
| 4 | 76 | 88 | 100 | 4 | ... | 84 | 96 | 0 | -1 | -1 | 0 | 0 | -1 | -1 | -1 | -1 |
| 5 | 75 | 90 | 105 | 11 | ... | 85 | 100 | -1 | -1 | -1 | -1 | 0 | 0 | -1 | -1 | -1 |
| 6 | 74 | 88 | 102 | 7 | ... | 47 | 61 | -1 | -1 | -1 | -1 | -1 | 0 | 0 | -1 | -1 |
| 7 | 65 | 70 | 75 | 80 | ... | 32 | 37 | -1 | -1 | -1 | -1 | -1 | -1 | 0 | 0 | -1 |
| 8 | 68 | 76 | 84 | 92 | ... | 37 | 45 | -1 | -1 | -1 | -1 | -1 | -1 | -1 | 0 | 0 |
| 9 | 89 | 100 | 3 | 14 | ... | 60 | 71 | 82 | -1 | -1 | -1 | -1 | -1 | -1 | -1 | 0 |

FIG. 7 - $H_{exp-3}$

EP 2 211 470 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *IEEE Std 802.16e - Air Interface for Fixed and Mobile Broadband Wireless Access Systems,* 28 February 2006

- **Jon G. Proakis.** DIGITAL COMMUNICATIONS. Mc-Graw-Hill, 2001